# EUROPEAN PATENT APPLICATION

(11) **EP 4 481 827 A1**
(43) Date of publication of application: **25.12.2024**
(21) Application number: 23756344.0
(22) Date of filing: 14.02.2023
(51) Int. Cl.: H01L 27/146

(54) **PHOTODETECTION DEVICE AND ELECTRONIC INSTRUMENT**

(30) Priority: 15.02.2022 US 202263310267 P
(71) Applicant: Sony Semiconductor Solutions Corporation, Atsugi-shi, Kanagawa 243-0014 (JP)
(72) Inventor: YONEDA, Kazuhiro, Atsugi-shi, Kanagawa 243-0014 (JP); DAICHO, Akira, Atsugi-shi, Kanagawa 243-0014 (JP); FUKUNAGA, Hiroshi, Atsugi-shi, Kanagawa 243-0014 (JP); OTAKE, Yusuke, Atsugi-shi, Kanagawa 243-0014 (JP); ENDO, Suzunori, Atsugi-shi, Kanagawa 243-0014 (JP); NAKAZAWA, Keiichi, Atsugi-shi, Kanagawa 243-0014 (JP); OISHI, Hidetoshi, Atsugi-shi, Kanagawa 243-0014 (JP)
(74) Representative: MFG Patentanwälte Meyer-Wildhagen Meggle-Freund Gerhard PartG mbB
(86) International application number: PCT/JP2023/004902
(87) International publication number: WO 2023/157819

(57) **Abstract**

A photodetector according to one embodiment of the present disclosure includes a semiconductor layer, a plurality of pixels including a first pixel including a photoelectric conversion element provided in the semiconductor layer, and a trench provided between the plurality of pixels adjacent to each other in the semiconductor layer. The first pixel includes a transistor provided on a side of a first surface of the semiconductor layer, a first semiconductor region having a first conductivity type, which is provided on the side of the first surface of the semiconductor layer, and a first contact that is electrically coupled to the first semiconductor region. The first semiconductor region is in contact with the transistor.

## Description

### Technical Field

The present disclosure relates to a photodetector, and an electronic apparatus.

### Background Art

A device that includes a GND (ground) contact for each pixel and performs photoelectric conversion on entering light has been proposed (PTL 1).

### Citation List

### Patent Literature

PTL 1: International Publication No. WO2019/220945

### Summary of the Invention

It is desirable that a light-detecting device be compatible with miniaturization.

It is desired to provide a photodetector having an advantage in miniaturization.

A photodetector according to one embodiment of the present disclosure includes a semiconductor layer, a plurality of pixels including a first pixel including a photoelectric conversion element provided in the semiconductor layer, and a trench provided between the plurality of adjacent pixels in the semiconductor layer. The first pixel includes a transistor provided on a side of a first surface of the semiconductor layer, a first semiconductor region of a first conductivity type, which is provided on the side of the first surface of the semiconductor layer, and a first contact that is electrically coupled to the first semiconductor region. The first semiconductor region is in contact with the transistor.

A photodetector according to one embodiment of the present disclosure includes a first pixel provided in the semiconductor layer, a first region separating the first pixel and an adjacent pixel, and a trench including a second region in which a photoelectric conversion element provided in the first pixel is shielded in a plan view. In the plan view, the second region includes a first separator between a first floating diffusion region and a second floating diffusion region that are provided in the first pixel. In the plan view, the second region includes a second separator between a first transistor and a second transistor that are provided in the first pixel. The first pixel includes a first semiconductor region of a first conductivity type and a first contact that is electrically coupled to the first semiconductor region. In a plan view, the first semiconductor region is provided between the first separator and the second separator. The first semiconductor region is in contact with the first transistor and the second transistor.

An electronic apparatus according to one embodiment of the present disclosure includes an optical system and a photodetector that receives light transmitted through the optical system. The photodetector includes a semiconductor layer, a plurality of pixels including a first pixel including a photoelectric conversion element provided in the semiconductor layer, and a trench provided between a plurality of adjacent pixels in the semiconductor layer. The first pixel includes a transistor provided on a side of a first surface of the semiconductor layer, a first semiconductor region having a first conductivity type, which is provided on the side of the first surface of the semiconductor layer, and a first contact that is electrically coupled to the first semiconductor region. The first semiconductor region is in contact with the transistor.

An electronic apparatus according to one embodiment of the present disclosure includes an optical system and a photodetector that receives light transmitted through the optical system. The photodetector includes a first pixel provided in a semiconductor layer, and a trench including a first region separating the first pixel and an adjacent pixel and a second region in which a photoelectric conversion element provided in the first pixel is shielded in a plan view. In the plan view, the second region includes a first separator between a first floating diffusion region and a second floating diffusion region that are provided in the first pixel. In the plan view, the second region includes a second separator between a first transistor and a second transistor that are provided in the first pixel. The first pixel includes a first semiconductor region having a first conductivity type and a first contact that is electrically coupled to the first semiconductor region. In the plan view, the first semiconductor region is provided between the first separator and the second separator. The first semiconductor region is in contact with the first transistor and the second transistor.

### Brief Description of Drawings

[FIG. 1] FIG. 1 is a block diagram illustrating an example of a schematic configuration of an imaging device that is an example of a photodetector according to a first embodiment of the present disclosure.
[FIG. 2] FIG. 2 is a diagram illustrating an example of an arrangement of pixels in the imaging device according to the first embodiment of the present disclosure.
[FIG. 3] FIG. 3 is a diagram describing an example of a circuit configuration of pixels in the imaging device according to the first embodiment of the present disclosure.
[FIG. 4A] FIG. 4A is a diagram describing another example of the circuit configuration of the pixels in the imaging device according to the first embodiment of the present disclosure.
[FIG. 4B] FIG. 4B is a diagram describing another example of the circuit configuration of the pixels in the imaging device according to the first embodiment of the present disclosure.
[FIG. 5] FIG. 5 is a diagram illustrating an example of a planar configuration of the pixel in the imaging device according to the first embodiment of the present disclosure.
[FIG. 6] FIG. 6 is a diagram describing an example of a cross-sectional configuration of the pixel in the imaging device according to the first embodiment of the present disclosure.
[FIG. 7] FIG. 7 is a diagram describing an example of the cross-sectional configuration of the pixel in the imaging device according to the first embodiment of the present disclosure.
[FIG. 8] FIG. 8 is a diagram illustrating an example of an arrangement of pixel transistors in the imaging device according to the first embodiment of the present disclosure.
[FIG. 9] FIG. 9 is a diagram illustrating another example of an arrangement of pixel transistors in the imaging device according to the first embodiment of the present disclosure.
[FIG. 10] FIG. 10 is a diagram illustrating another example of an arrangement of the pixel transistors in the imaging device according to the first embodiment of the present disclosure.
[FIG. 11] FIG. 11 is a diagram illustrating an example of a cross-sectional configuration of the imaging device according to the first embodiment of the present disclosure.
[FIG. 12] FIG. 12 is a diagram illustrating an example of a planar configuration of a pixel in an imaging device according to Modification Example 1 of the present disclosure.
[FIG. 13] FIG. 13 is a diagram describing an example of a cross-sectional configuration of the pixel in the imaging device according to Modification Example 1 of the present disclosure.
[FIG. 14] FIG. 14 is a diagram describing an example of a planar configuration of the imaging device according to Modification Example 1 of the present disclosure.
[FIG. 15] FIG. 15 is a diagram describing an example of a cross-sectional configuration of the imaging device according to Modification Example 1 of the present disclosure.
[FIG. 16] FIG. 16 is a diagram describing another example of the cross-sectional configuration of the pixel in the imaging device according to Modification Example 1 of the present disclosure.
[FIG. 17] FIG. 17 is a diagram describing another example of the cross-sectional configuration of the pixel in the imaging device according to Modification Example 1 of the present disclosure.
[FIG. 18] FIG. 18 is a diagram illustrating an example of a planar configuration of a pixel in an imaging device according to Modification Example 2 of the present disclosure.
[FIG. 19] FIG. 19 is a diagram describing an example of a planar configuration of the imaging device according to Modification Example 2 of the present disclosure.
[FIG. 20] FIG. 20 is a diagram illustrating an example of a planar configuration of a pixel in an imaging device according to Modification Example 3 of the present disclosure.
[FIG. 21] FIG. 21 is a diagram describing an example of a cross-sectional configuration of the pixel in the imaging device according to Modification Example 3 of the present disclosure.
[FIG. 22] FIG. 22 is a diagram illustrating another example of the planar configuration of a pixel in the imaging device according to Modification Example 3 of the present disclosure.
[FIG. 23] FIG. 23 is a diagram describing another example of the cross-sectional configuration of the pixel in the imaging device according to Modification Example 3 of the present disclosure.
[FIG. 24] FIG. 24 is a diagram describing another example of the cross-sectional configuration of the pixel in the imaging device according to Modification Example 3 of the present disclosure.
[FIG. 25] FIG. 25 is a diagram illustrating another example of the planar configuration of a pixel in the imaging device according to Modification Example 3 of the present disclosure.
[FIG. 26] FIG. 26 is a diagram describing another example of the cross-sectional configuration of the pixel in the imaging device according to Modification Example 3 of the present disclosure.
[FIG. 27] FIG. 27 is a diagram describing another example of the cross-sectional configuration of the pixel in the imaging device according to Modification Example 3 of the present disclosure.
[FIG. 28] FIG. 28 is a diagram describing an example of arrangement of pixel transistors in an imaging device according to Modification Example 4 of the present disclosure.
[FIG. 29] FIG. 29 is a diagram describing another example of arrangement of pixel transistors in the imaging device according to Modification Example 4 of the present disclosure.
[FIG. 30] FIG. 30 is a diagram describing another example of arrangement of pixel transistors in the imaging device according to Modification Example 4 of the present disclosure.
[FIG. 31] FIG. 31 is a diagram describing another example of arrangement of pixel transistors in the imaging device according to Modification Example 4 of the present disclosure.
[FIG. 32] FIG. 32 is a diagram describing another example of arrangement of pixel transistors in the imaging device according to Modification Example 4 of the present disclosure.
[FIG. 33] FIG. 33 is a diagram describing another example of arrangement of pixel transistors in the imaging device according to Modification Example 4 of the present disclosure.
[FIG. 34] FIG. 34 is a diagram describing another example of arrangement of pixel transistors in the imaging device according to Modification Example 4 of the present disclosure.
[FIG. 35] FIG. 35 is a diagram describing another example of arrangement of pixel transistors in the imaging device according to Modification Example 4 of the present disclosure.
[FIG. 36] FIG. 36 is a diagram illustrating an example of an arrangement of pixels in an imaging device according to a second embodiment of the present disclosure.
[FIG. 37] FIG. 37 is a diagram illustrating an example of a planar configuration of a pixel in the imaging device according to the second embodiment of the present disclosure.
[FIG. 38] FIG. 38 is a diagram illustrating another example of the planar configuration of a pixel in the imaging device according to the second embodiment of the present disclosure.
[FIG. 39] FIG. 39 is a diagram illustrating an example of a planar configuration of a pixel in an imaging device according to Modification Example 5 of the present disclosure.
[FIG. 40] FIG. 40 is a diagram describing an example of a cross-sectional configuration of the pixel in the imaging device according to Modification Example 5 of the present disclosure.
[FIG. 41] FIG. 41 is a diagram describing another example of the cross-sectional configuration of a pixel in the imaging device according to the Modification Example 5 of the present disclosure.
[FIG. 42] FIG. 42 is a diagram describing another example of the planar configuration of a pixel in the imaging device according to Modification Example 5 of the present disclosure.
[FIG. 43A] FIG. 43A is a diagram describing an example of a configuration of a pixel in an imaging device according to Modification Example 6 of the present disclosure.
[FIG. 43B] FIG. 43B is a diagram describing an example of the configuration of the pixel of the imaging device according to Modification Example 6 of the present disclosure.
[FIG. 44] FIG. 44 is a diagram describing an example of a configuration of a pixel in an imaging device according to a Modification Example 7 of the present disclosure.
[FIG. 45] FIG. 45 is a diagram illustrating an example of a planar configuration of the pixel in the imaging device according to Modification Example 7 of the present disclosure.
[FIG. 46] FIG. 46 is a diagram illustrating an example of a planar configuration of a pixel in an imaging device according to Modification Example 8 of the present disclosure.
[FIG. 47] FIG. 47 is a diagram illustrating another example of the planar configuration of a pixel in the imaging device according to Modification Example 8 of the present disclosure.
[FIG. 48] FIG. 48 is a diagram illustrating an example of a planar configuration of a pixel in an imaging device according to Modification Example 9 of the present disclosure.
[FIG. 49] FIG. 49 is a diagram describing an example of a cross-sectional configuration of the pixel in the imaging device according to the Modification Example 9 of the present disclosure.
[FIG. 50] FIG. 50 is a diagram describing another example of the planar configuration of a pixel in the imaging device according to Modification Example 9 of the present disclosure.
[FIG. 51] FIG. 51 is a diagram illustrating an example of a planar configuration of a pixel in an imaging device according to Modification Example 10 of the present disclosure.
[FIG. 52] FIG. 52 is a diagram illustrating another example of the planar configuration of a pixel in the imaging device according to Modification Example 10 of the present disclosure.
[FIG. 53] FIG. 53 is a diagram illustrating another example of the planar configuration of a pixel in the imaging device according to Modification Example 10 of the present disclosure.
[FIG. 54] FIG. 54 is a block diagram illustrating an example of a configuration of an electronic apparatus including an imaging device.
[FIG. 55] FIG. 55 is a block diagram depicting an example of schematic configuration of a vehicle control system.
[FIG. 56] FIG. 56 is a diagram of assistance in explaining an example of installation positions of an outside-vehicle information detecting section and an imaging section.
[FIG. 57] FIG. 57 is a view depicting an example of a schematic configuration of an endoscopic surgery system.
[FIG. 58] FIG. 58 is a block diagram depicting an example of a functional configuration of a camera head and a camera control unit (CCU).

### Modes for Carrying Out the Invention

In the following, some embodiments of the present disclosure will be described in detail with reference to the drawings. It is to be noted that the description will be given in the following order.
1. First Embodiment
2. Second Embodiment
3. Application Example
4. Practical Application Examples

### <First Embodiment>

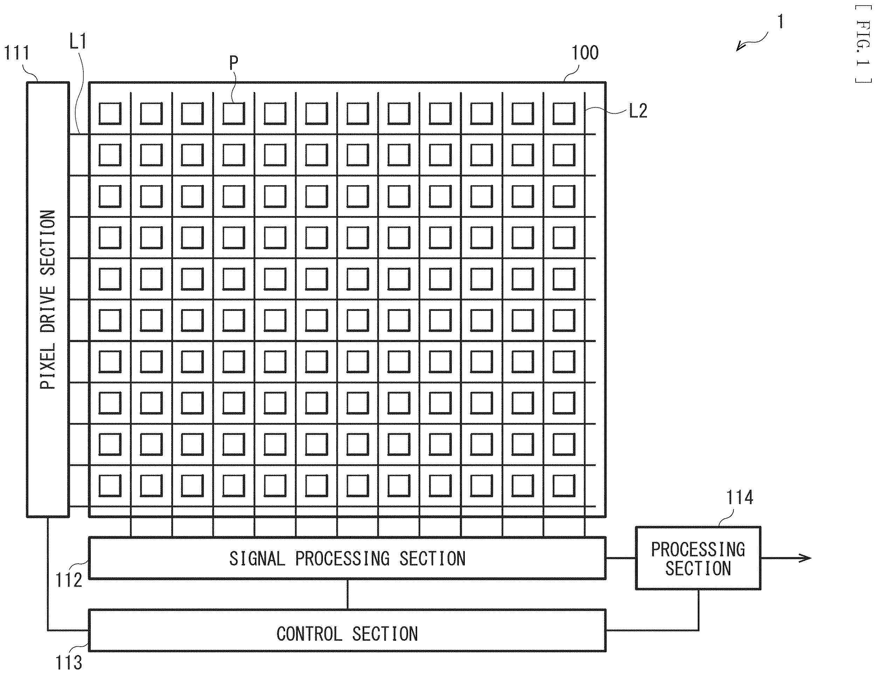

FIG. 1 is a block diagram illustrating an example of a schematic configuration of an imaging device as one example of a photodetector according to a first embodiment of the present disclosure. The photodetector is a device able to detect entering light. An imaging device 1, which is the photodetector, includes a plurality of pixels P including a photoelectric conversion section (photoelectric conversion element) and is configured to generate a signal by performing photoelectric conversion on light that has entered. The imaging device 1 (photodetector) may receive light transmitted through an optical system including an optical lens (not illustrated) and may generate a signal.

For example, the imaging device 1 is configured using a semiconductor substrate (for example, a silicon substrate) on which a plurality of pixels P is provided. For example, the photoelectric conversion section in each pixel P in the imaging device 1 is a photodiode (PD) and is configured to perform photoelectric conversion on light. The imaging device 1 includes, as an imaging area, a region (pixel section 100) in which a plurality of pixels P is two-dimensionally arranged in a matrix. The pixel section 100 can also be referred to as a pixel array in which the plurality of pixels P is arranged.

The imaging system 1 captures light (image light) entering from a subject via an optical system including an optical lens. The imaging device 1 captures an image of the subject, which is formed by the optical lens. The imaging device 1 may perform photoelectric conversion on the received light to generate a pixel signal. For example, the imaging device 1 is a CMOS (Complementary Metal Oxide Semiconductor) image sensor. The imaging device 1 is applicable to, for example, an electronic apparatus such as a digital still camera, a video camera, and a mobile phone.

As in the example illustrated in FIG. 1, the imaging device 1 includes, for example, a pixel drive section 111, a signal processing section 112, a control section 113, a processing section 114, and the like in a peripheral region of the pixel section 100 (pixel array). In addition, the imaging device 1 includes a plurality of control lines L1 and a plurality of signal lines L2.

The control lines L1 are each a signal line that is able to transmit a signal to control each pixel P and are coupled to the pixel drive section 111 and to the pixels P in the pixel section 100. In the example illustrated in FIG. 1, in the pixel section 100, a plurality of control lines L1 is provided for each pixel row that includes a plurality of pixels P arranged in a horizontal direction (row direction). Each control line L1 is configured to transmit a control signal to read a signal from each pixel P.

In the imaging device 1, the plurality of control lines L1 for each pixel row includes, as an example, a wiring line that transmits a signal to control a transfer transistor, a wiring line that transmits a signal to control a selection transistor, a wiring line that transmits a signal to control a reset transistor, or the like. Each control line L1 can also be referred to as a drive line (pixel drive line) that transmits a signal to drive a pixel P.

The signal lines L2 are each a signal line that is able to transmit a signal from each pixel P and are coupled to the pixels P in the pixel section 100 and to the signal processing section 112. In the pixel section 100, for example, the signal lines L2 are each provided for each pixel column, which includes a plurality of pixels P arranged in a vertical direction (column direction). Each signal line L2 is a vertical control line and is configured to transmit a signal outputted from each pixel P.

The pixel drive section 111 is configured to drive each pixel P in the pixel section 100. The pixel drive section 111 is a drive circuit and includes, for example, a plurality of circuits including a buffer, a shift register, an address decoder, and the like. The pixel drive section 111 generates a signal to drive the pixels P and outputs the signal to each pixel P in the pixel section 100 via the control line L1. The pixel drive section 111 is controlled by the control section 113 to perform control on the pixels P in the pixel section 100.

For example, the pixel drive section 111 generates a signal to control the pixels P such as a signal to control the transfer transistor of the pixels P, a signal to control the selection transistor, and a signal to control the reset transistor, and supplies the signal to each pixel P through the control lines L1. The pixel drive section 111 may perform control to read a pixel signal from each pixel P. The pixel drive section 111 can also be referred to as a pixel control section that is configured to control each pixel P. It is to be noted that the pixel drive section 111 and the control section 113 together can be referred to as the pixel control section.

The signal processing section 112 is configured to perform signal processing on the inputted pixel signal. The signal processing section 112 is a signal processing circuit and includes, for example, a load circuit section, an AD (Analog Digital) conversion section, a horizontal selection switch, or the like. It is to be noted that the signal processing section 112 may include an amplifying circuit section configured to amplify the signal read from each pixel P via each signal line L2.

The signal selectively scanned by the pixel drive section 111 and outputted from each pixel P is inputted to the signal processing section 112 via each signal line L2. The signal processing section 112, for example, may perform signal processing on the signal of each pixel P, such as AD conversion and CDS (Correlated Double Sampling: correlated double sampling). The signal of each pixel P transmitted through each signal line L2 is processed by the signal processing section 112 and outputted to the processing section 114.

The processing section 114 is configured to perform signal processing on the inputted signal. The processing section 114 is a signal processing circuit and includes, for example, a circuit that performs various signal processing on the pixel signal. The processing section 114 may include a processor and a memory. The processing section 114 performs signal processing on the pixel signal inputted from the signal processing section 112 and outputs the pixel signal after the processing. The processing section 114, for example, may perform various signal processing such as noise reduction processing and gray-scale correction processing.

The control section 113 is configured to control each section in the imaging device 1. The control section 113 may receive a clock, data commanding an operation mode, or the like that is supplied from outside, and also may output data such as internal information of the imaging device 1. The control section 113 is a control circuit and includes, for example, a timing generator configured to generate various timing signals.

The control section 113 performs drive control on the pixel drive section 111, the signal processing section 112, and the like on the basis of various timing signals (a pulse signal, a clock signal, and the like) generated by the timing generator. It is to be noted that the control section 113 and the processing section 114 may be integrally configured.

The pixel drive section 111, the signal processing section 112, the control section 113, the processing section 114, and the like. may be provided on one semiconductor substrate or may be provided separately on a plurality of semiconductor substrates. The imaging device 1 may have a configuration (stacked configuration) in which a plurality of substrates is stacked.

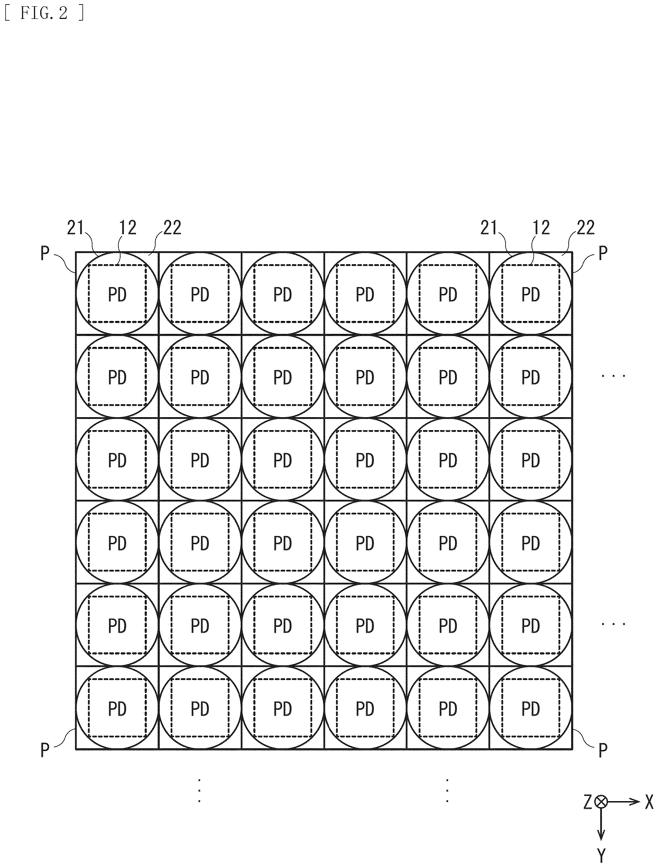

FIG. 2 is a diagram illustrating an example of an arrangement of pixels in the imaging device according to the first embodiment. Each pixel P in the imaging device 1 includes a photoelectric conversion section 12 and a lens 21. It is to be noted that as illustrated in FIG. 2, a direction in which light enters from the subject is assumed to be a Z-axis direction, a horizontal direction on paper that is orthogonal to the Z-axis direction is assumed to be an X-axis direction, and a vertical direction on paper that is orthogonal to the Z-axis direction and the X-axis direction is assumed to be a Y-axis direction. In subsequent drawings, in some cases, a direction will be indicated with reference to an arrow direction in FIG. 2.

The lens 21 is an optical member that is also referred to as an on-chip lens. For example, the lens 21 is provided above the photoelectric conversion section 12 for each pixel P or for a plurality of pixels P. Light from the subject enters the lens 21 via an optical system such as an imaging lens. The photoelectric conversion section 12 performs photoelectric conversion on the light entering through the lens 21.

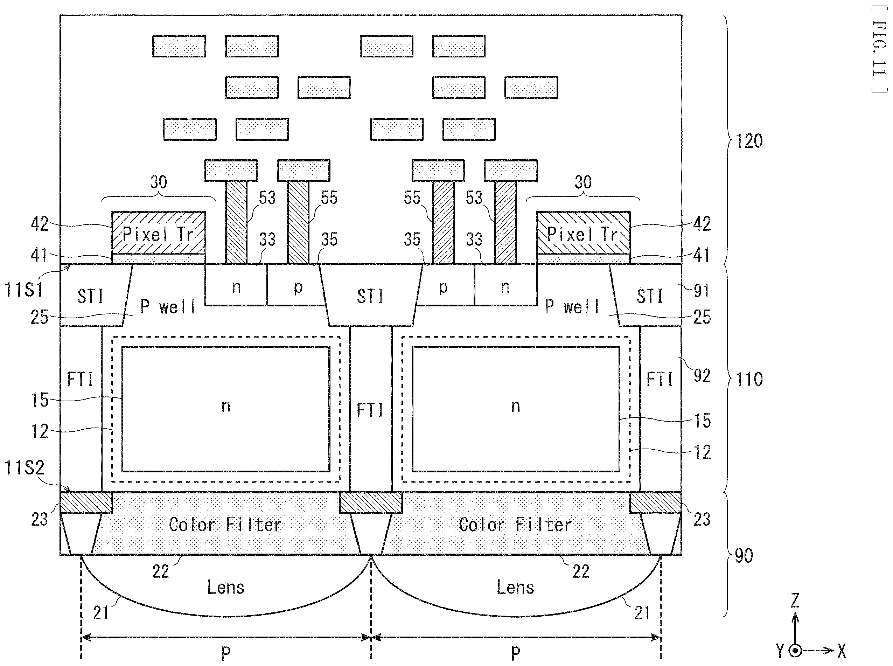

In addition, each pixel P may include a filter 22 (also see FIG. 11 described later). The filter 22 is configured to selectively transmit light having a specific wavelength range out of the entering light. For example, the filter 22 is an RGB color filter, a filter transmitting infrared light, or the like.

The plurality of pixels P provided in the pixel section 100 in the imaging device 1 include a plurality of pixels (R pixels) each including the filter 22 transmitting red (R) light, a plurality of pixels (G pixels) each including the filter 22 transmitting green (G) light, and a plurality of pixels (B pixels) each including the filter 22 transmitting blue (B) light. In the pixel section 100, the plurality of R pixels, the plurality of G pixels, and the plurality of B pixels are repeatedly arranged. The R pixels, the G pixels, and the B pixels are arranged in accordance with Bayer arrangement, for example.

As an example, it is possible to arrange the R, G, and B pixels on a basis of 2 × 2 pixels. For example, in the pixel section 100, four adjacent R pixels, four adjacent G pixels, and four adjacent B pixels are arranged repeatedly. It can also be said that the R pixels, the G pixels, and the B pixels are arranged periodically in two rows by two columns.

The R pixel, the G pixel, and the B pixel generate, respectively, a pixel signal having an R component, a pixel signal a G component, and a pixel signal having a B component. For the imaging device 1, it is possible to obtain pixel signals in RGB. It is to be noted that the arrangement of pixels is not limited to the example described above, but any setting is possible.

The filter 22 provided in each pixel P in the pixel section 100 is not limited to a primary (RGB) color filter, but may also be a complementary color filter such as Cy (cyan), Mg (magenta), and Ye (yellow). A filter corresponding to W (white), that is, a filter transmitting light in an entire wavelength range of entering light, may be provided.

In addition, in the imaging device 1, the filter 22 may be omitted as necessary. For example, it is not necessary to provide the filter 22 in the pixel P that receives white (W) light and performs photoelectric conversion. In addition, it is not necessary to provide the filter 22 in all or a part of the pixels P in the imaging device 1.

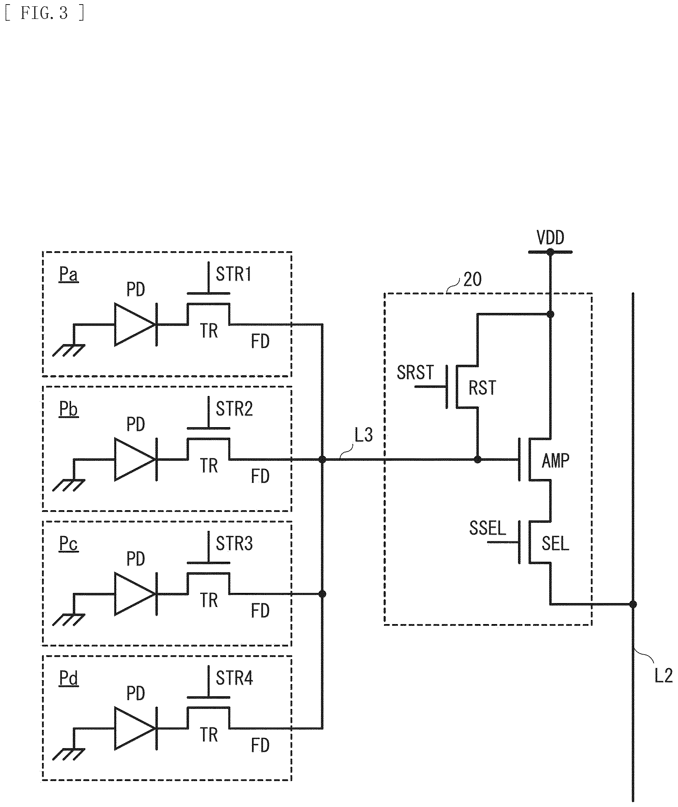

FIG. 3 is a diagram describing an example of a circuit configuration of a pixel in the imaging device according to the first embodiment. The pixel P in the imaging device 1 includes a photoelectric conversion section 12 (photoelectric conversion element), a transfer transistor TR, a floating diffusion FD, and a reading circuit 20. The photoelectric conversion section 12 is configured to receive light and generate a signal. The photoelectric conversion section 12 is a light-receiving section (light-receiving element) and is configured to generate electric charge through photoelectric conversion.

The reading circuit 20 is configured to output a signal based on the photoelectrically-converted electric charge. In the imaging device 1, the reading circuit 20 is provided for a plurality of pixels P. The imaging device 1 has a configuration in which the plurality of pixels P shares one reading circuit 20. This makes it possible to reduce the number of elements (for example, the number of transistors) for one pixel P (or for one photoelectric conversion section 12). It is possible for the imaging device 1 to have an advantageous configuration for pixel miniaturization.

In the example illustrated in FIG. 3, the reading circuit 20 is provided for every four pixels P (referred to as pixel Pa to pixel Pd). The pixels Pa, Pb, Pc, and Pd share one reading circuit 20. For example, 2 × 2 pixels including adjacent pixels Pa to Pd share one reading circuit 20. The imaging device 1 may read each pixel signal from 2 × 2 pixels by operating the reading circuit 20 by time division. In addition, it is also possible for the imaging device 1 to add each signal from the 2 × 2 pixels to read out a pixel signal.

In the example illustrated in FIG. 3, the photoelectric conversion section 12 is a photodiode (PD), which converts entering light into electric charge. The photoelectric conversion section 12 (the photodiode PD in each of the pixels Pa to Pd) performs photoelectric conversion to generate electric charge corresponding to an amount of light received.

The transfer transistor TR (in FIG. 3, the transfer transistor TR in each of the pixels Pa to Pd) is configured to transfer, to the floating diffusion FD, the electric charge that is photoelectrically converted by the photoelectric conversion section 12. The transfer transistor TR is controlled by a signal STR to electrically connect or disconnect the photoelectric conversion section 12 and the floating diffusion FD. The transfer transistor TR may transfer, to the floating diffusion FD, the electric charge that is photoelectrically converted and accumulated in the photoelectric conversion section 12.

In the example illustrated in FIG. 3, on-off control is performed on the transfer transistor TR in each of the pixels Pa to Pd by signals different from each other. The transfer transistor TR of the pixel Pa is controlled by a signal STR1, and the transfer transistor TR of the pixel Pb is controlled by a signal STR2. In addition, the transfer transistor TR of the pixel Pc is controlled by a signal STR3, and the transfer transistor TR of the pixel Pd is controlled by a signal STR4.

The floating diffusion FD is an accumulating section and is configured to accumulate the transferred electric charge. The floating diffusion FD may accumulate the electric charge that is photoelectrically converted by the photoelectric conversion section 12. The floating diffusion FD can also be referred to as a holding section that is able to hold the transferred electric charge. The floating diffusion FD accumulates the transferred electric charge and converts the electric charge into a voltage corresponding to a capacitance of the floating diffusion FD.

As an example, as illustrated in FIG. 3, the reading circuit 20 includes an amplifying transistor AMP, a selection transistor SEL, and a reset transistor RST. The amplifying transistor AMP is configured to generate and output a signal based on the electric charge accumulated in the floating diffusion FD. As illustrated in FIG. 3, a gate of the amplifying transistor AMP is electrically coupled to the floating diffusion FD in each pixel P, and a voltage converted by the floating diffusion FD is inputted thereto.

A drain of the amplifying transistor AMP is coupled to a power supply line to which a power supply voltage VDD is supplied, and a source of the amplifying transistor AMP is coupled to the signal line L2 via the selection transistor SEL. The amplifying transistor AMP may generate a signal based on the electric charge accumulated in the floating diffusion FD, that is, a signal based on the voltage at the floating diffusion FD, and may output to the signal line L2.

The selection transistor SEL is configured to control an output of the pixel signal. The selection transistor SEL is controlled by a signal SSEL and is configured to output a signal from the amplifying transistor AMP to the signal line L2. The selection transistor SEL may control an output timing of the pixel signal. It is to be noted that the selection transistor SEL may be provided between the power supply line to which the power supply voltage VDD is supplied and the amplifying transistor AMP. In addition, the selection transistor SEL may be omitted as necessary.

The reset transistor RST is configured to reset the voltage of the floating diffusion FD. In the example illustrated in FIG. 3, the reset transistor RST is electrically coupled to the power supply line to which the power supply voltage VDD is supplied and is configured to reset the electric charge of the pixel P.

The reset transistor RST is controlled by a signal SRST and may reset the electric charge accumulated in the floating diffusion FD, and may reset the voltage of the floating diffusion FD. It is to be noted that the reset transistor RST may discharge the electric charge accumulated in the photoelectric conversion section 12 via the transfer transistor TR.

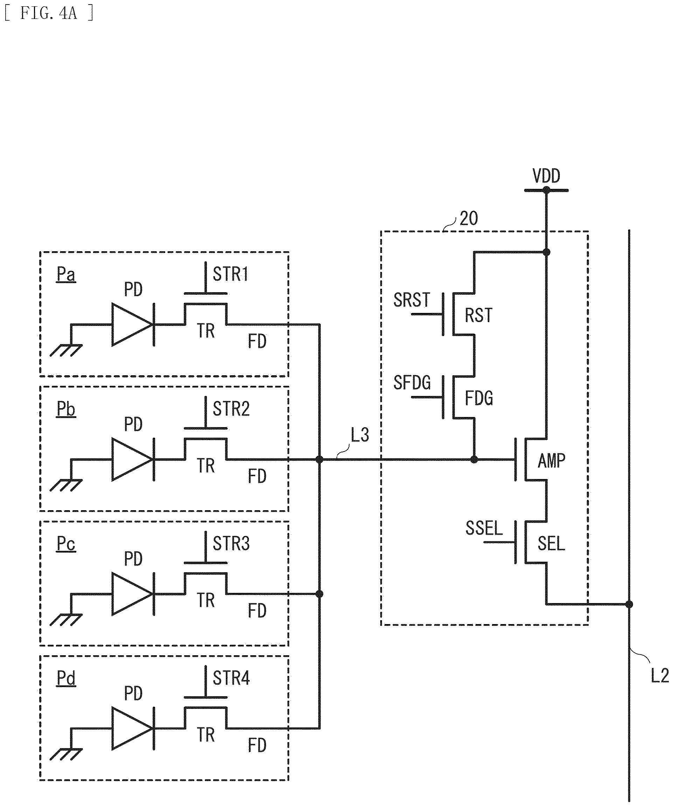

FIG. 4A is a diagram describing another example of the circuit configuration of a pixel in the imaging device according to the first embodiment. As in the example illustrated in FIG. 4A, the reading circuit 20 may include a transistor FDG. As an example, the transistor FDG is configured to electrically couple the floating diffusion FD and the reset transistor RST. For example, the transistor FDG is controlled by a signal SFDG to electrically connect or disconnect the floating diffusion FD and the reset transistor RST.

As a result of turning on the transistor FDG, a larger capacitance is added to the floating diffusion FD in the pixel P, making it possible to change a conversion efficiency (gain) in converting the electric charge into the voltage. The transistor FDG is a switching transistor that switches the capacitance coupled to the gate of the amplifying transistor AMP to change the conversion efficiency.

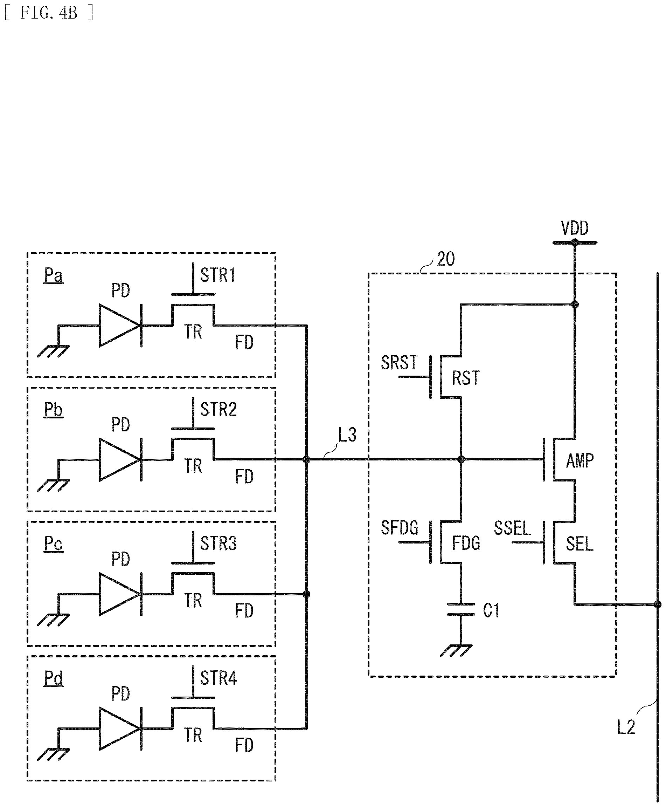

The transistor FDG may be coupled in series to the reset transistor RST or may be coupled in parallel to the reset transistor RST. As in the example illustrated in FIG. 4B, the transistor FDG may be configured to electrically couple the floating diffusion FD and a capacitive element C1. For example, the transistor FDG is controlled by the signal SFDG to electrically connect or disconnect the floating diffusion FD and the capacitive element C1. It is possible to change the conversion efficiency by switching a connection state of the capacitive element C1.

The transfer transistor TR, the amplifying transistor AMP, the selection transistor SEL, the transistor FDG (switching transistor), and the reset transistor RST as described above are each a MOS transistor (MOSFET) including gate, source, and drain terminals.

In the examples illustrated in FIG. 3 and FIGs. 4A and 4B, the transfer transistor TR, the amplifying transistor AMP, the selection transistor SEL, the transistor FDG, and the reset transistor RST are each configured by a NMOS transistor. It is to be noted that each transistor in the pixel P may be configured using a PMOS transistor. The transistors in the pixel P (the transfer transistor TR, the amplifying transistor AMP, the selection transistor SEL, the transistor FDG, the reset transistor RST, or the like) may be a 3D transistor, for example, a Fin-type transistor (Fin FET).

The pixel drive section 111 (see FIG. 1) supplies a control signal to the gate of the transfer transistor TR, the selection transistor SEL, the transistor FDG, the reset transistor RST, or the like in each pixel P via the control lines L1 described above, to turn the transistors on (conducting state) or off (nonconducting state).

The plurality of control lines L1 in the imaging device 1 includes a wiring line transmitting the signal STR to control the transfer transistor TR, a wiring line transmitting the signal SSEL to control the selection transistor SEL, a wiring line transmitting the signal SFDG to control the transistor FDG, a wiring line transmitting the signal SRST to control the reset transistor RST, and the like.

The pixel drive section 111 performs on-off control on the transfer transistor TR, the selection transistor SEL, the transistor FDG, the reset transistor RST, and the like. The pixel drive section 111 controls the reading circuit 20 in each pixel P, thereby causing the pixel signal to be outputted from each pixel P to the signal line L2. The pixel drive section 111 may perform control to read the pixel signal from each pixel P to the signal line L2.

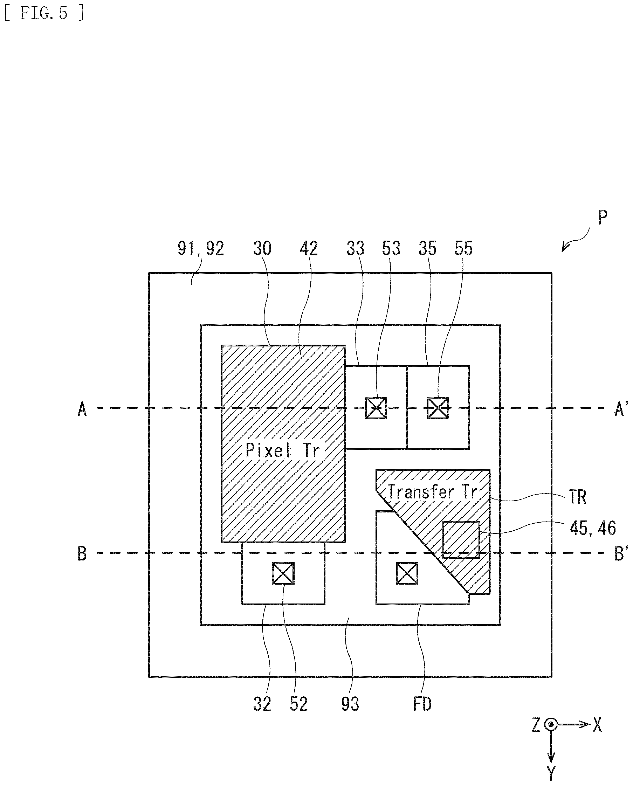

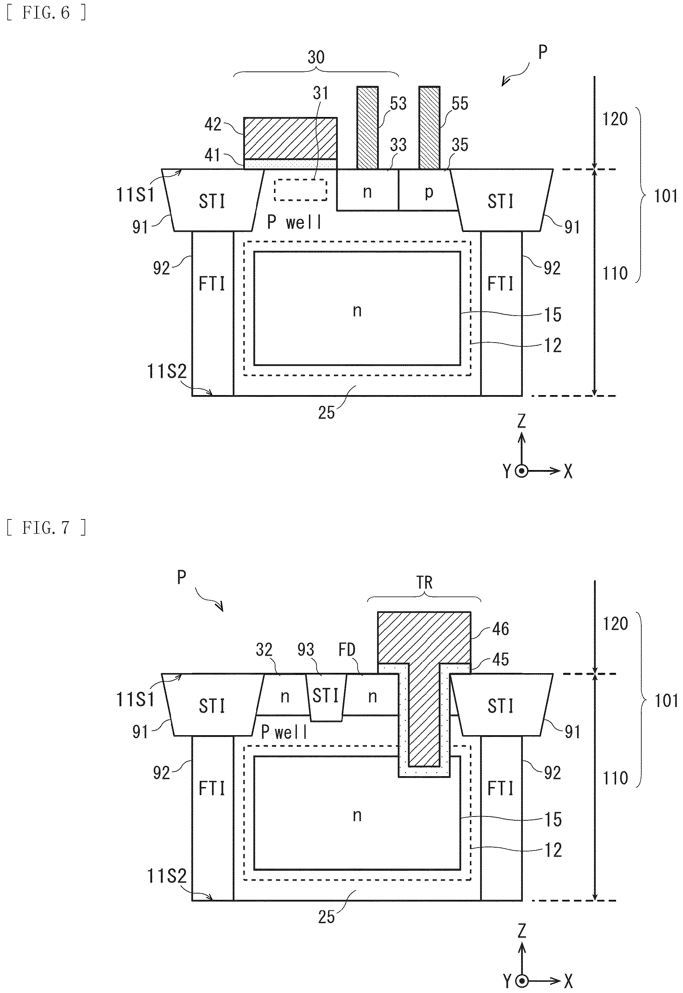

FIG. 5 is a diagram illustrating an example of a planar configuration of a pixel in the imaging device according to the first embodiment. FIGs. 6 and 7 describe examples of a cross-sectional configuration of a pixel in the imaging device. FIG. 6 illustrates an example of the configuration of the pixel in a direction along line A-A' illustrated in FIG. 5. FIG. 7 illustrates an example of the configuration of the pixel in a direction along line B-B' illustrated in FIG. 5.

For example, each pixel P in the imaging device 1 has a configuration as illustrated in FIGs. 5 to 7. The pixel P includes the photoelectric conversion section 12, the transfer transistor TR, the floating diffusion FD, a pixel transistor 30, and a semiconductor region 35. For example, the pixel transistor 30 is the transistor in the reading circuit 20 as described above.

The pixel transistor 30 is used as the amplifying transistor AMP, the selection transistor SEL, the transistor FDG, the reset transistor RST, or the like. It is to be noted that the pixel transistor 30 in a portion of the pixels P may be a dummy transistor. The reading circuit 20 may include the dummy transistor as the pixel transistor 30.

For example, each transistor in the reading circuit 20, such as the amplifying transistor AMP, the selection transistor SEL, the transistor FDG, and the reset transistor RST, is provided separately as the pixel transistor 30 in a plurality of pixels P and shared by the plurality of pixels P. Configuring the imaging device 1 in this manner makes it possible to reduce the number of transistors in one pixel P.

The imaging device 1 is configured using a substrate 101 including a semiconductor layer 110. For example, the substrate 101 includes a semiconductor substrate, for example, a Si (silicon) substrate. On the substrate 101 including the semiconductor layer 110, the photoelectric conversion section 12, the reading circuit 20, and the like as described above are formed, for example.

It is to be noted that the substrate 101 may include a SOI (Silicon On Insulator) substrate, a SiGe (Silicon-Germanium) substrate, another compound semiconductor material, or the like. In the examples illustrated in FIGs. 5 to 7, the substrate 101 includes the semiconductor layer 110 and a wiring layer 120.

As illustrated in FIGs. 6 and 7, the semiconductor layer 110 includes a first surface 11S1 and a second surface 11S2 that are opposed to each other. The second surface 11S2 is a surface on an opposite side of the first surface 11S1. The first surface 11S1 of the semiconductor layer 110 is an element-forming surface on which an element such as a transistor is formed. A gate electrode, a gate oxide film, and the like are provided on the first surface 11S1 of the semiconductor layer 110. The second surface 11S2 of the semiconductor layer 110 is a light-receiving surface (light-entering surface).

In the semiconductor layer 110, a plurality of photoelectric conversion sections 12 (photoelectric conversion elements) are provided along the first surface 11S1 and the second surface 11S2 of the semiconductor layer 110. For example, the plurality of photoelectric conversion sections 12 is buried in the semiconductor layer 110.

As illustrated in FIGs. 6 and 7, the semiconductor layer 110 has a well 25. For example, the well 25 is a p-type semiconductor region and is a p-type well (p-well). In the examples illustrated in FIGs. 6 and 7, in the semiconductor layer 110, the well 25 that is a p-type well region is provided. The photoelectric conversion section 12 includes a semiconductor region 15 provided in the well 25. The semiconductor region 15 is an n-type semiconductor region, for example.

On a side of the first surface 11S1 of the semiconductor layer 110, the transfer transistor TR, the floating diffusion FD, the pixel transistor 30, the semiconductor region 35, and the like are provided. As illustrated in FIG. 7, for example, the floating diffusion FD includes an n-type semiconductor region.

As illustrated in FIGs. 5 to 7, the imaging device 1 has a trench 91 and a trench 92. The trench 91 and the trench 92 are each provided between a plurality of adjacent pixels P in the semiconductor layer 110. The trench 91 and the trench 92 are provided between each photoelectric conversion section 12 in the plurality of adjacent pixels P to separate the pixels P (or photoelectric conversion sections 12). It can also be said that each pixel P has a configuration partitioned by the trench 91 and the trench 92.

The trench 91 and the trench 92 are each a separator (groove) including, for example, an insulating material. At least a portion of each of the trench 91 and the trench 92 is provided at a boundary between adjacent pixels P. The trench 91 has an STI (Shallow Trench Isolation) configuration and is provided on the side of the first surface 11S1 of the semiconductor layer 110. The trench 92 has an FTI (Full Trench Isolation) configuration and is provided to penetrate through the semiconductor layer 110.

In the examples illustrated in FIGs. 5 to 7, in the semiconductor layer 110, the trench 91 is provided to surround the transfer transistor TR, the floating diffusion FD, the pixel transistor 30, the semiconductor region 35, and the like. In addition, in the semiconductor layer 110, the trench 92 is provided to surround the photoelectric conversion section 12. In a plan view, the trench 91 and the trench 92 are provided in a grid pattern to surround each photoelectric conversion section 12 in each pixel P. The trench 91 and the trench 92 can also be referred to as an inter-pixel separator or an inter-pixel separation wall.

As an example, the trench 91 and the trench 92 includes an insulating film (insulator) such as an oxide film (for example, a silicon oxide film) or a nitride film (for example, a silicon nitride film). In the trench 91 and the trench 92, polysilicon, a metal material, or the like may be buried. In addition, the trench 91 and the trench 92 may have a void (cavity). The trench 92 may be included in the trench 91. For example, the trench 92 may be provided from within the trench 91 provided on the side of the first surface 11S1 of the semiconductor layer 110 to the second surface 11S2 of the semiconductor layer 110.

In addition, the imaging device 1 has a trench 93. The trench 93 is a separator (groove) having an STI configuration. In the trench 93, for example, an insulating film such as an oxide film (for example, a silicon oxide film), a nitride film (for example, a silicon nitride film), or the like is provided. The trench 93 is provided on the side of the first surface 11S1 of the semiconductor layer 110 to separate each element. The trench 93 may be provided between the pixel transistor 30 and the floating diffusion FD, between the transfer transistor TR and the semiconductor region 35, and so on.

The semiconductor region 35 is provided on the side of the first surface 11S1 of the semiconductor layer 110. The semiconductor region 35 is a semiconductor region of the same conductivity type as the well 25. The semiconductor region 35 is provided in the well 25 and is electrically coupled to the well 25. For example, the semiconductor region 35 is a p-type semiconductor region, which is a region formed using a p-type impurity.

For example, the semiconductor region 35 has an impurity concentration higher than the impurity concentration of the well 25 and is a p+ type semiconductor region. The semiconductor region 35, which is a p+ type region, is a p+ type diffusion region and can also be referred to as a p+ type conductive region. In addition, the semiconductor region 35 is electrically coupled to a contact 55 provided in the wiring layer 120.

In the example illustrated in FIG. 6, the semiconductor region 35 is coupled to the contact 55 provided on the semiconductor region 35 to be electrically coupled to a wiring line (not illustrated) in the wiring layer 120 via the contact 55. The contact 55 is electrically coupled to the well 25 by the semiconductor region 35.

The contact 55, for example, is coupled to the semiconductor region 35 by ohmic contact to be electrically coupled to the well 25 via the semiconductor region 35. Through the wiring line in the wiring layer 120, the contact 55, and the like, a predetermined potential (voltage) is supplied to the well 25 region that is electrically coupled to the semiconductor region 35.

The contact 55 is a well contact, and the semiconductor region 35 is a well contact region. For example, the contact 55 and the semiconductor region 35 are provided for each pixel P. It is to be noted that the semiconductor region 35 and the contact 55 together can be referred to as the well contact region.

For example, the semiconductor region 35 is electrically coupled to a reference potential line in the wiring layer 120 via the contact 55, and a reference potential is supplied to the semiconductor region 35 and the well 25. As an example, the semiconductor region 35 and the well 25 are supplied with a GND potential (ground potential) via the contact 55.

The pixel transistor 30 includes a semiconductor region 31, a semiconductor region 32, a semiconductor region 33, a gate insulating film 41, and a gate electrode 42. The semiconductor regions 31 to 33 are each provided in the well 25. It can also be said that the semiconductor regions 32, 33, and the like are disposed to replace a portion of the well 25. The semiconductor region 31 and the semiconductor region 32 (or the semiconductor region 33) have a conductivity type different from each other.

The semiconductor region 31 is a region in which a channel is formed (channel region). For example, the semiconductor region 31 is a p-type semiconductor region, which is a region formed using a p-type impurity. The semiconductor region 31 is a p-type diffusion region, and can also be referred to as a p-type conductive region.

The semiconductor region 32 and the semiconductor region 33 are a source region and a drain region of the pixel transistor 30. One of the semiconductor regions 32 and 33 is the source region of the pixel transistor 30, and another of the semiconductor regions 32 and 33 is the drain region of the pixel transistor 30.

For example, the semiconductor region 32 and the semiconductor region 33 are each an n-type semiconductor region, which is a region formed using an n-type impurity. For example, the semiconductor region 32 and the semiconductor region 33 are formed by doping (adding) an n-type impurity to a region of the semiconductor layer 110. For example, the semiconductor region 32 and the semiconductor region 33 are each an n-type diffusion region and can also be referred to as an n-type conductive region.

The semiconductor region 32 is coupled to a contact 52 provided on the semiconductor region 32 to be electrically coupled to the wiring line (not illustrated) in the wiring layer 120 via the contact 52. The semiconductor region 33 is coupled to a contact 53 provided on the semiconductor region 33 to be electrically coupled to the wiring line in the wiring layer 120 via the contact 53.

The semiconductor region 32 and the semiconductor region 33 are provided around the gate electrode 42 of the pixel transistor 30. The pixel transistor 30 including the semiconductor regions 32 and 33 is formed in a region around the transfer transistor TR. In the example illustrated in FIG. 5, the pixel transistor 30 has an L-shape in a plan view. It is to be noted that the shape of the pixel transistor 30 is not limited to the example illustrated in FIG. 5 and the like, and is changeable as appropriate.

The gate insulating film 41 of the pixel transistor 30 is provided on the channel region (semiconductor region 31) of the semiconductor layer 110. The gate insulating film 41 (for example, a gate oxide film) is provided between the semiconductor region 31 that is the channel region and the gate electrode 42. The gate electrode 42 is provided on the gate insulating film 41. The gate electrode 42 is provided above the semiconductor region 31 of the semiconductor layer 110 via the gate insulating film 41.

The transfer transistor TR includes a gate insulating film 45 and a gate electrode 46. At least a portion of each of the gate insulating film 45 and the gate electrode 46 of the transfer transistor TR is provided in the semiconductor layer 110. As in the example illustrated in FIG. 7 and the like, for example, at least a portion of each of the gate insulating film 45 and the gate electrode 46 is engraved in the semiconductor layer 110. As an example, the transfer transistor TR has a vertical gate configuration. The transfer transistor TR can also be referred to as a vertical transistor. The transfer transistor TR may have a planar gate configuration. The transfer transistor TR may be a planar-type transistor.

In the example illustrated in FIG. 7, for example, a portion of each of the gate electrode 46 and the gate insulating film 45 of the transfer transistor TR is provided to be buried in the semiconductor layer 110. The gate electrode 46 may be provided in the semiconductor layer 110, from between the floating diffusion FD and the trench 91 to the region of the photoelectric conversion section 12. The gate insulating film 45 is formed along the gate electrode 46 in the semiconductor layer 110.

The gate insulating film 41 of the pixel transistor 30 and the gate insulating film 45 of the transfer transistor TR each include, for example, a single layer film including one type from among silicon oxide (SiO), silicon oxynitride (SiON), hafnium oxide (HfO), and the like, or a laminated film including two or more types from these. The gate insulating films 41 and 45 may include a high dielectric constant material having a dielectric constant higher than the dielectric constant of silicon oxide, such as a hafnium-based insulating film.

For example, the gate electrode 42 of the pixel transistor 30 and the gate electrode 46 of the transfer transistor TR include polysilicon (Poly-Si). The gate electrodes 42 and 46 may be configured using a metal material or a metal compound. The gate electrodes 42 and 46 may include, for example, titanium nitride (TiN), tantalum nitride (TaN), tungsten, or the like.

The contact 52, the contact 53, and the contact 55 each include a conductive material. For example, each of the contacts 52, 53, and 55 is formed by burying (filling) a conductive material such as tungsten (W) into a contact hole. It is to be noted that ach of the contacts 52, 53, and 55 may include a metal material such as aluminum (Al) and copper (Cu), or may include another material.

In the imaging device 1, the semiconductor region 35 is provided in contact with the pixel transistor 30. For example, the semiconductor region 35 is disposed in contact with the source region or the drain region of the pixel transistor 30 in the pixel P. In the examples illustrated in FIGs. 5 to 7 and the like, the semiconductor region 35 is disposed in contact with the semiconductor region 33 in the pixel transistor 30, on the side of the first surface 11S1 of the semiconductor layer 110.

It is to be noted that being "in contact" in the present disclosure includes a case of having a direct contact and a case of having a contact via a natural oxide film or the like. A state in which "the semiconductor region 35 and the semiconductor region 33 are in contact" includes a case where a natural oxide film is interposed, and includes a case where the semiconductor region 35 is in contact with the semiconductor region 33 via a thin natural oxide film. Furthermore, being "in contact" represents that there is no insulating film functioning as STI (Shallow Trench Isolation), no impurity region functioning as a channel stop region (having a different function from the semiconductor region 33 and the semiconductor region 35), or no well region between the semiconductor regions. However, in a case where the semiconductor region 33 of the N type and the semiconductor region 35 of the P type are in contact with each other, a layer depleted by PN junction is formed in a boundary surface.

For example, the semiconductor region 35 is provided in contact with a lateral surface (side part) of the semiconductor region 33, which is the source or drain region of the pixel transistor 30. It is to be noted that the semiconductor region 35 may be provided in contact with the semiconductor region 32. The semiconductor region 35 may be provided to be adjacent to the gate of the pixel transistor 30.

Thus, in the present embodiment, the semiconductor region 35 is provided in contact with the pixel transistor 30. This allows the imaging device 1 to have an advantageous configuration for miniaturization. Compared with a case where the semiconductor region 35 and the pixel transistor 30 are provided apart from each other, it is possible to increase the area of a region in which to dispose a transistor or the like in each pixel P. This makes it possible to increase a size of the transistor to be disposed in the pixel P.

In the present embodiment, as in the example illustrated in FIG. 5, it is possible to increase the area of the pixel transistor 30. It is possible to increase a size of the transistor, for example, the amplifying transistor AMP in the reading circuit 20, making it possible to suppress noise mixed into the pixel signal.

It is possible, in particular, to increase an area efficiency in a fine pixel, and increase the size of the pixel transistor 30 (for example, a gate length, a gate width, and the like). This makes it possible to improve a characteristic of the transistor in the reading circuit 20 (such as the amplifying transistor AMP, the selection transistor SEL, the transistor FDG, and the reset transistor RST). Accordingly, it becomes possible to suppress deterioration in the quality of pixel signals, making it possible to suppress deterioration in image quality.

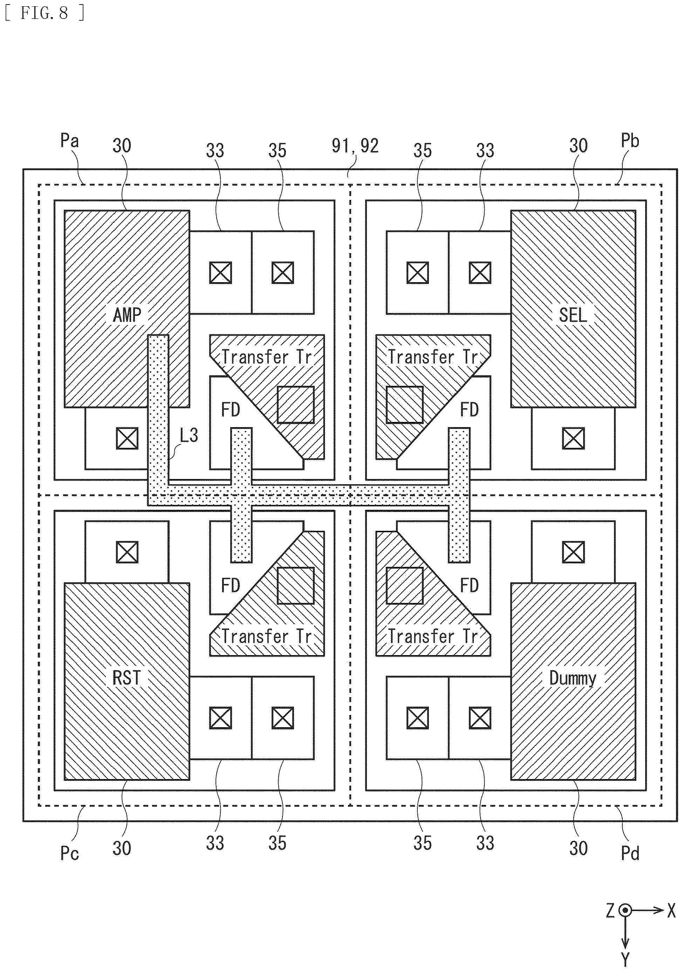

FIG. 8 is a diagram illustrating an example of an arrangement of pixel transistors in the imaging device according to the first embodiment. FIG. 8 illustrates 2 × 2 pixels, assuming four pixels P sharing the reading circuit 20 to be pixels Pa to Pd. A plurality of pixels P other than these pixels P in the imaging device 1 may have a similar configuration to the configuration illustrated in FIG. 8.

In the example illustrated in Figure 8, the amplifying transistor AMP is provided in the pixel Pa as the pixel transistor 30. In the pixel Pb, the selection transistor SEL is provided as the pixel transistor 30. In the pixel Pc, the reset transistor RST is provided as the pixel transistor 30. In addition, in the pixel Pd, a dummy transistor is provided as the pixel transistor 30.

For example, in the imaging device 1, a wiring line L3 is provided as in the example illustrated in FIG. 8. The floating diffusion FD in each of the plurality of pixels P sharing the reading circuit 20 in common is electrically coupled to the transistor in the reading circuit 20 via the wiring line L3. In the example illustrated in FIG. 8, the floating diffusion FD in each of the pixels Pa to Pd is electrically coupled, via the wiring line L3, to the gate electrode of the amplifying transistor AMP that is the pixel transistor 30 in the pixel Pa.

The wiring line L3 is the wiring line shared by the four pixels Pa to Pd. For example, the wiring line L3 is provided using a metal material such as aluminum (Al) or tungsten (W). It is to be noted that the wiring line L3 may include poly-silicon (Poly-Si) or another conductive material.

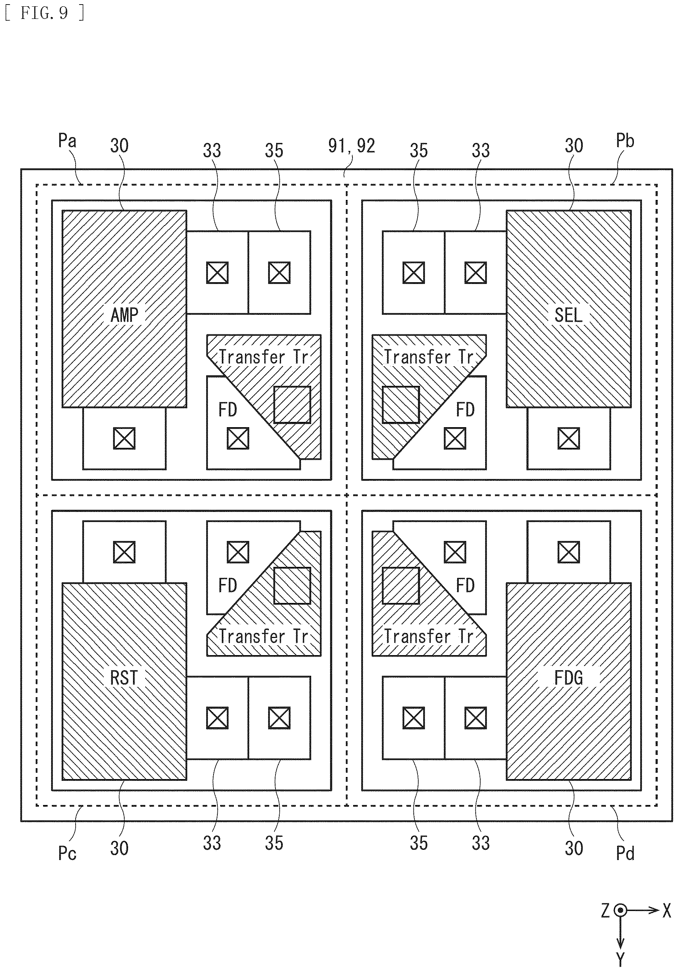

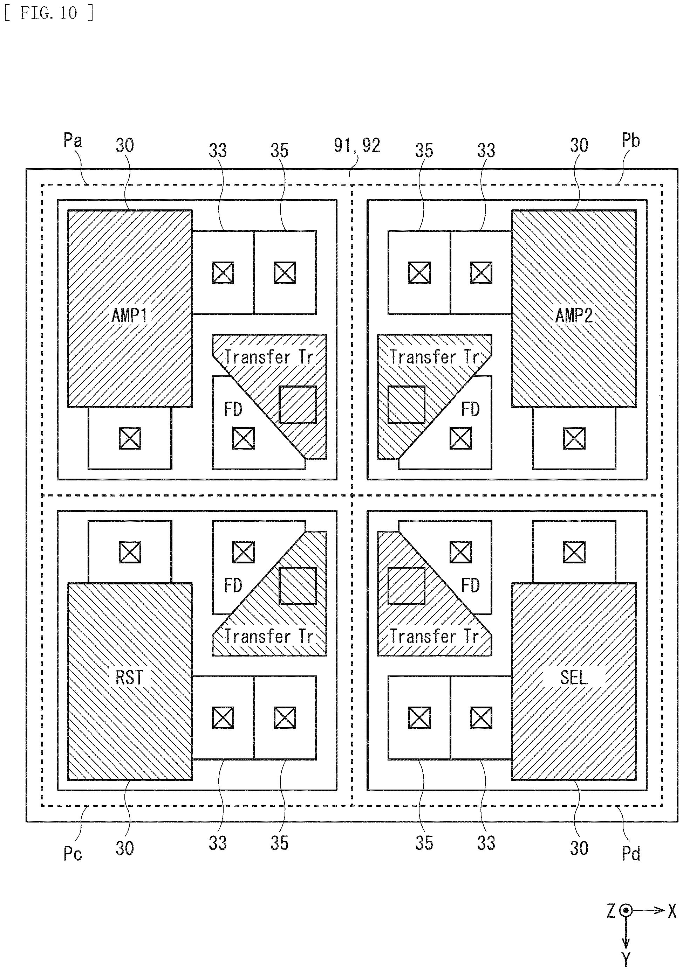

FIGs. 9 and 10 are diagrams each illustrating another example of an arrangement of pixel transistors in the imaging device according to the first embodiment. Each transistor in the reading circuit 20 may be arranged as illustrated in FIG. 9 or FIG. 10. In the example illustrated in FIG. 9, the reading circuit 20 includes the amplifying transistor AMP, the selection transistor SEL, the reset transistor RST, and the transistor FDG.

In the example illustrated in FIG. 9, the pixel Pa includes the amplifying transistor AMP as the pixel transistor 30. The pixel Pb includes the selection transistor SEL as the pixel transistor 30. The pixel Pc includes the reset transistor RST as the pixel transistor 30. In addition, the pixel Pd includes the transistor FDG as the pixel transistor 30.

The reading circuit 20 may include a plurality of amplifying transistors AMP (in FIG. 10, an amplifying transistor AMP1 and an amplifying transistor AMP2) coupled in parallel with each other. In the example illustrated in FIG. 10, the amplifying transistor AMP1 is disposed in the pixel Pa, and the amplifying transistor AMP2 is disposed in the pixel Pb. The reading circuit 20 may generate and output a pixel signal by the amplifying transistors AMP1 and AMP2 coupled in parallel with each other. This makes it possible to reduce noise mixed into the pixel signal.

FIG. 11 is a diagram illustrating an example of a cross-sectional configuration of the imaging device according to the first embodiment. As illustrated in FIG. 11, for example, the imaging device 1 has a configuration in which a light guide section 90, the semiconductor layer 110, and the wiring layer 120 are stacked in the Z-axis direction.

In the example illustrated in FIG. 11, the wiring layer 120 is provided on the side of the first surface 11S1 of the semiconductor layer 110. On the side of the second surface 11S2 of the semiconductor layer 110, the light guide section 90 is provided. The light guide section 90 is provided on a side on which light from the optical system enters, and the wiring layer 120 is provided on a side opposite to the side on which the light enters. The imaging device 1 is what is called a back-illuminated imaging device.

For example, the wiring layer 120 includes a conductor film and an insulating film, and includes a plurality of wiring lines and vias (VIA), and the like. The wiring layer 120 includes, for example, two or more layers of wiring lines. The wiring layer 120 may include five or more layers of wiring lines. The wiring layer 120 has a configuration in which a plurality of wiring lines is stacked with an insulating film in between. The insulating film of the wiring layer 120 can also be referred to as an interlayer insulating film (interlayer insulating layer).

The wiring line in the wiring layer 120, for example, is formed using a metal material such as aluminum (Al), copper (Cu), and tungsten (W). The wiring line in the wiring layer 120 may include polysilicon (Poly-Si) or another conductive material. The interlayer insulating film, for example, is formed using silicon oxide (SiO), silicon nitride (SiN), silicon oxynitride (SiON), or the like.

In the semiconductor layer 110 and the wiring layer 120, for example, the photoelectric conversion section 12, the reading circuit 20, and the like are provided as described above. It is to be noted that the-above described pixel drive section 111, signal processing section 112, control section 113, and processing section 114, and the like may be provided on a substrate other than the semiconductor layer 110 or in the semiconductor layer 110 and the wiring layer 120,.

The trench 91 and the trench 92 are provided between adjacent photoelectric conversion sections 12, to separate the photoelectric conversion sections 12. The trenches 91 and 92 are provided in the semiconductor layer 110 to surround each photoelectric conversion section 12. As illustrated in FIG. 8 and the like, the trenches 91 and 92 are formed in a lattice state in a plan view and disposed to surround each of the plurality of photoelectric conversion sections 12.

The light guide section 90 illustrated in FIG. 11 is stacked on the semiconductor layer 110 in a thickness direction orthogonal to the second surface 11S2 of the semiconductor layer 110. The light guide section 90 has the lens 21 and the filter 22, guiding entering light toward the side of the semiconductor layer 110.

For example, the lens 21 is provided on the filter 22 for each pixel P or a plurality of pixels P. Light from a subject enters the lens 21 through an optical system such as an imaging lens. The photoelectric conversion section 12 performs photoelectric conversion on the light entering through the lens 21 and the filter 22.

As illustrated in FIG. 11, a light-shielding section 23 is provided in the imaging device 1. The light-shielding section 23 (light-shielding film) includes a light-shielding member and is provided at the boundary of a plurality of adjacent pixels P. For example, the light-shielding section 23 (light-shielding member) may be provided between adjacent filters 22 and may be located at the boundary between the adjacent filters 22.

The light-shielding section 23 includes, for example, a light-shielding metal material (aluminum (Al), tungsten (W), copper (Cu), or the like). The light-shielding section 23 may also include a light-absorbing material. Providing the light-shielding section 23 prevents leakage of light into a pixel P in a surrounding area. This makes it possible to suppress leakage of unnecessary light into the surrounding area, thus making it possible to prevent occurrence of color mixing.

It is to be noted that the imaging device 1 may include an anti-reflection film and a fixed charge film. For example, the fixed charge film is provided between the semiconductor layer 110 and the filter 22. As an example, the fixed charge film includes a metal compound (metal oxide, metal nitride, or the like). For example, the fixed charge film is a film having a negative fixed charge, and suppresses generation of a dark current at a boundary surface of the semiconductor layer 110.

The anti-reflection film includes, for example, an insulating material such as silicon nitride (SiN) and silicon oxide (SiO). For example, the anti-reflection film is provided between the semiconductor layer 110 and the filter 22 to reduce (suppress) reflection.

### [Workings and Effects]

The photodetector according to the present embodiment includes a semiconductor layer (semiconductor layer 110), a plurality of pixels that includes a first pixel (for example, pixel Pa) having a photoelectric conversion element (photoelectric conversion section 12) provided in the semiconductor layer, and a trench (trench 91 and trench 92) provided between a plurality of adjacent pixels in the semiconductor layer. The first pixel includes a transistor (pixel transistor 30) provided on the side of the first surface of the semiconductor layer, a first semiconductor region (semiconductor region 35) of a first conductivity type, which is provided on the side of the first surface of the semiconductor layer, and a first contact (contact 55) that is electrically coupled to the first semiconductor region. The first semiconductor region is in contact with the transistor.

In the photodetector (imaging device 1) according to the present embodiment, the semiconductor region 35 is in contact with the pixel transistor 30. The semiconductor region 35 is provided in contact with the semiconductor region 33, which is the source region or the drain region of the pixel transistor 30. This allows the imaging device 1 to have an advantageous configuration for pixel miniaturization. It becomes possible to increase the size of the pixel transistor, making it possible to improve a characteristic of the pixel transistor. It becomes possible to achieve a photodetector having an advantage for miniaturization.

Next, some modification examples of the present disclosure will be described. In the following, components similar to those in the above embodiment will be denoted by the same reference numerals, and the description thereof will be omitted as appropriate.

### (1-1. Modification Example)

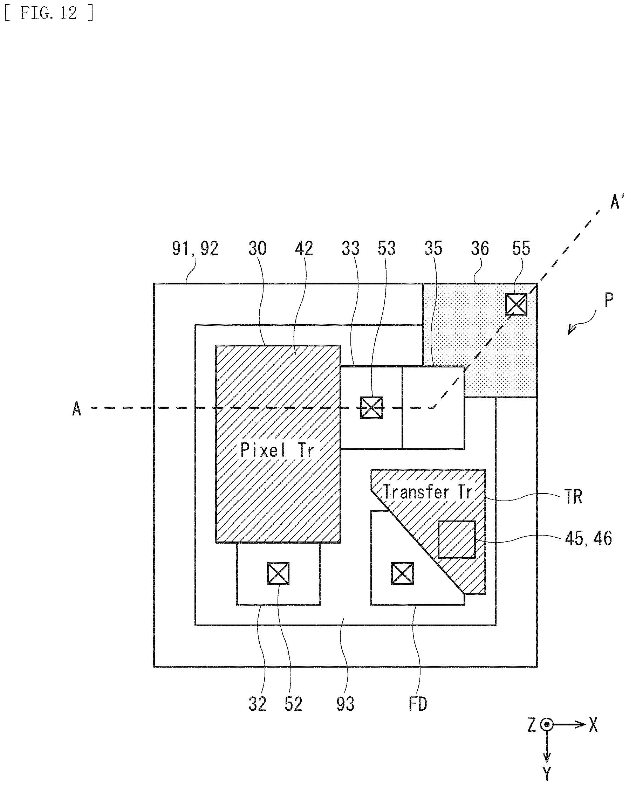

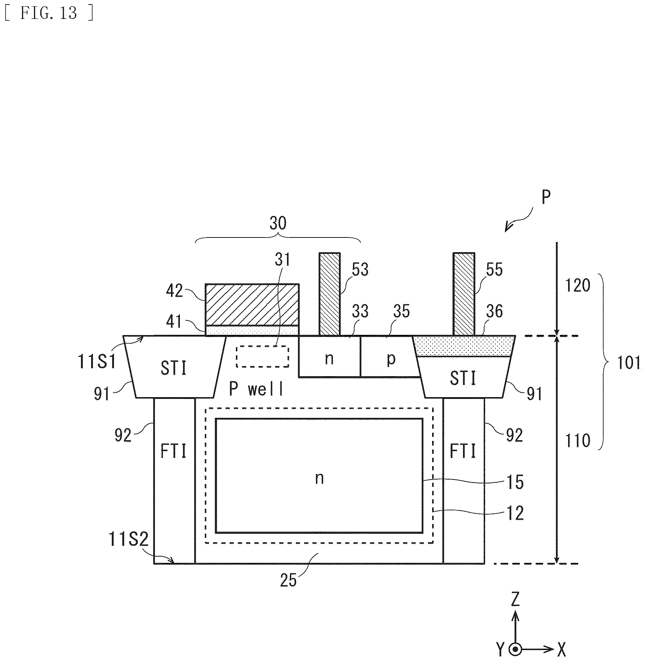

FIG. 12 is a diagram illustrating an example of a planar configuration of a pixel in an imaging device according to Modification Example 1 of the present disclosure. FIG. 13 is a diagram describing an example of a cross-sectional configuration of a pixel in the imaging device. FIG. 13 schematically illustrates an example of the configuration of the pixel in a direction along line A-A' illustrated in FIG. 12.

In the imaging device 1 according to the present modification example, as illustrated in FIGs. 12 and 13, a conductor region 36 is provided. The conductor region 36 is provided around the semiconductor region 35. At least a portion of the conductor region 36 is provided in contact with the semiconductor region 35. On the side of the first surface 11S1 of the semiconductor layer 110, the conductor region 36 is formed adjacent to the semiconductor region 35. In the example illustrated in FIG. 13, the conductor region 36 is located in an upper portion in the trenches 91 and 92.

For example, the conductor region 36 includes polysilicon doped (added) with an impurity. It is to be noted that the conductor region 36 (conductive section) may be configured using another conductive material (for example, a metal material or the like). For example, the conductor region 36 has an impurity concentration higher than the impurity concentration of the well 25.

The contact 55 is provided on the conductor region 36. The contact 55 is electrically coupled to the semiconductor region 35 and the well 25 via the conductor region 36. In the imaging device 1 according to the present modification example, the semiconductor region 35 provided in the well 25 and the contact 55 are electrically coupled via the conductor region 36. This makes it possible to reduce the impurity concentration of the semiconductor region 35, which is necessary for electrically coupling the semiconductor region 35 to the contact 55.

Reducing the impurity concentration in the semiconductor region 35 makes it possible to reduce an electric field (potential gradient) between the semiconductor region 35 and the source region or the drain region of the pixel transistor 30 (the semiconductor region 33 in FIG. 13). This makes it possible to suppress generation of a defect in the pixel transistor 30. It becomes possible to prevent an increase in noise mixed into the pixel signal.

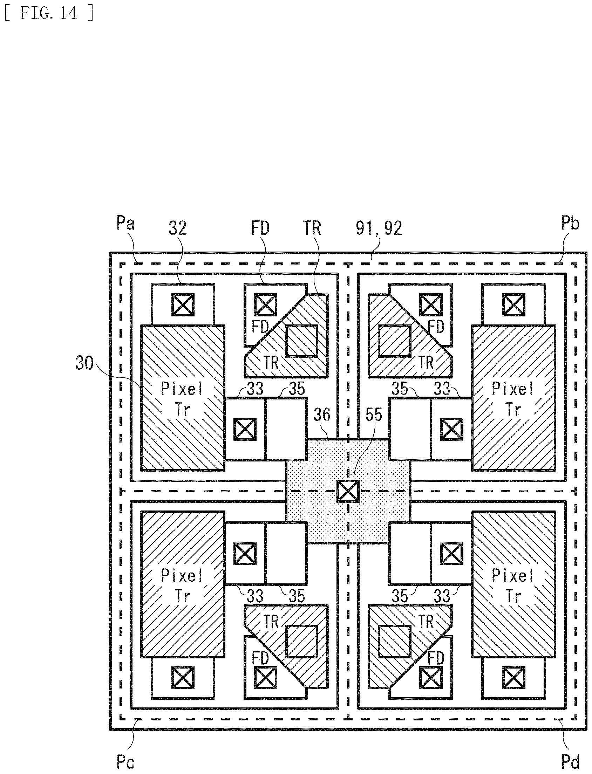

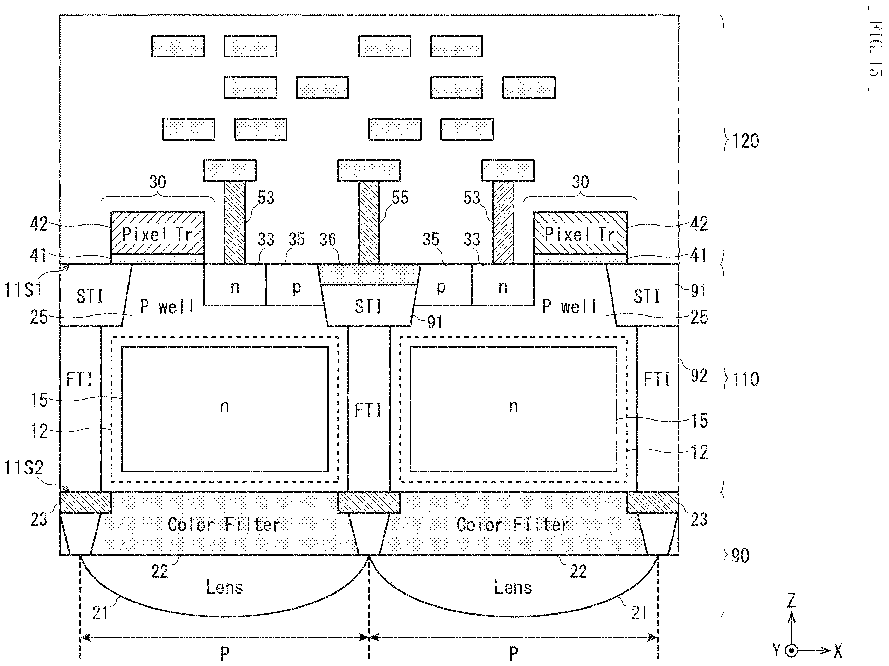

FIG. 14 is a diagram illustrating an example of a planar configuration of the imaging device according to Modification Example 1. FIG. 15 is a diagram describing an example of a cross-sectional configuration of the imaging device. As in the examples illustrated in FIGs. 14 and 15, the conductor region 36 may be provided. At least a portion of the conductor region 36 is provided at the boundary between a plurality of adjacent pixels P.

The semiconductor region 33 in each of the plurality of adjacent pixels P is electrically coupled to the contact 55 via the conductor region 36 that is shared in common. As described above, the conductor region 36 is provided in the semiconductor layer 110. In the examples illustrated in FIGs. 13, 15, and the like, the conductor region 36 is disposed in an upper portion in the trench 91. This makes it possible to prevent generation of an unnecessary parasitic capacitance in the imaging device 1. For example, it becomes possible to avoid addition of an unnecessary parasitic capacitance to the transistor in the reading circuit 20.

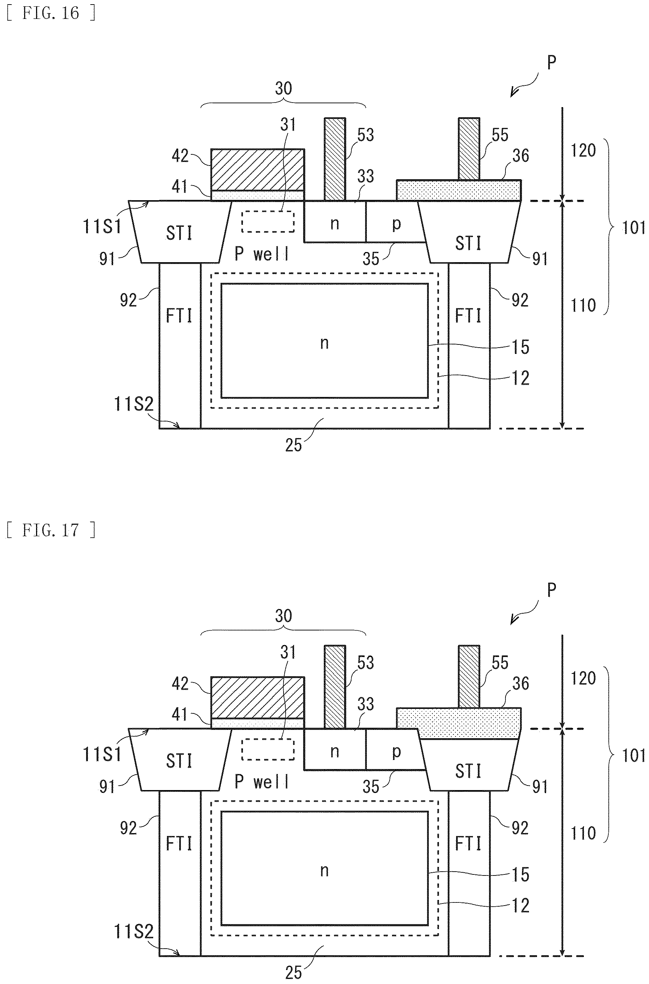

FIGs. 16 and 17 are diagrams illustrating another example of the cross-sectional configuration of the pixel in the imaging device according to Modification Example 1. As illustrated in FIG. 16, the conductor region 36 may be provided on the first surface 11S1 of the semiconductor layer 110. In the example illustrated in FIG. 16, the conductor region 36 is provided in the wiring layer 120. It is to be noted that as in the example illustrated in FIG. 17, a portion of the conductor region 36 may be provided in the semiconductor layer 110. A portion of the conductor region 36 may be formed in the trench 91.

### (1-2. Modification Example 2)

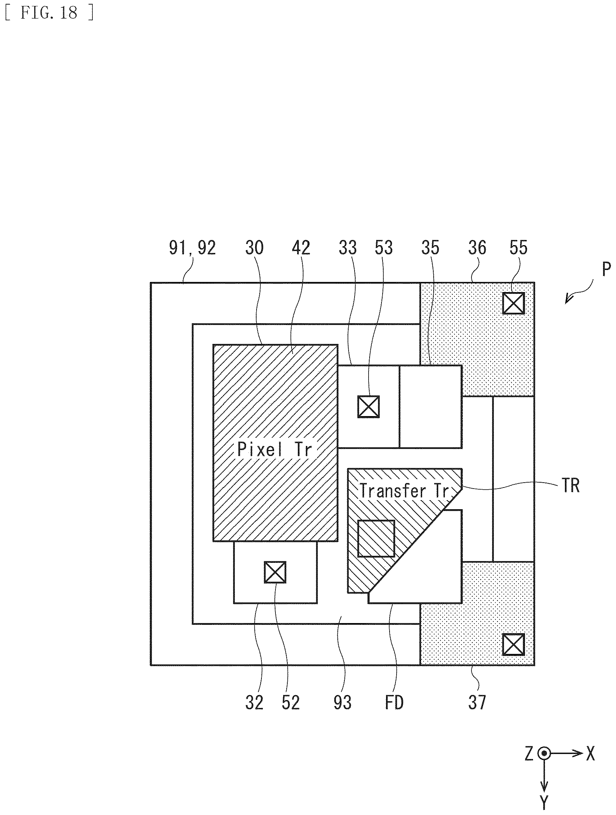

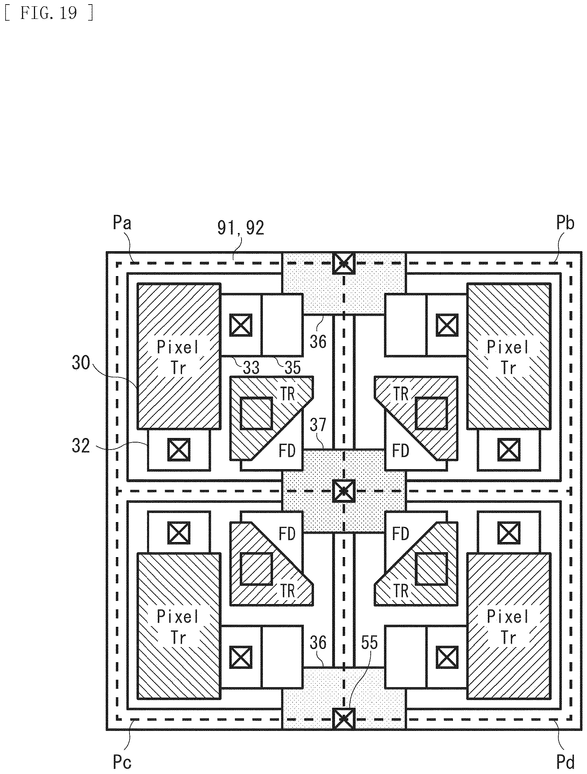

FIG. 18 is a diagram illustrating an example of a planar configuration of a pixel in an imaging device according to Modification Example 2. FIG. 19 is a diagram illustrating an example of the planar configuration of the imaging device according to Modification Example 2. As illustrated in FIGs. 18 and 19, the imaging device 1 may include a semiconductor region 37. The semiconductor region 37 is provided around the floating diffusion FD in the semiconductor layer 110.

As an example, the semiconductor region 37 includes polysilicon doped with an impurity. It is to be noted that the semiconductor region 37 may include another conductive material. At least a portion of the semiconductor region 37 is provided in contact with the floating diffusion FD.

The floating diffusion FD in each of the plurality of pixels P (the pixels Pa to Pd in FIG. 19) sharing the reading circuit 20 is electrically coupled to each other via the semiconductor region 37. The floating diffusion FD in each of the pixels Pa to Pd is electrically coupled to the amplifying transistor AMP, the reset transistor RST, and the like in the reading circuit 20 via the semiconductor region 37.

### (1-3. Modification Example 3)

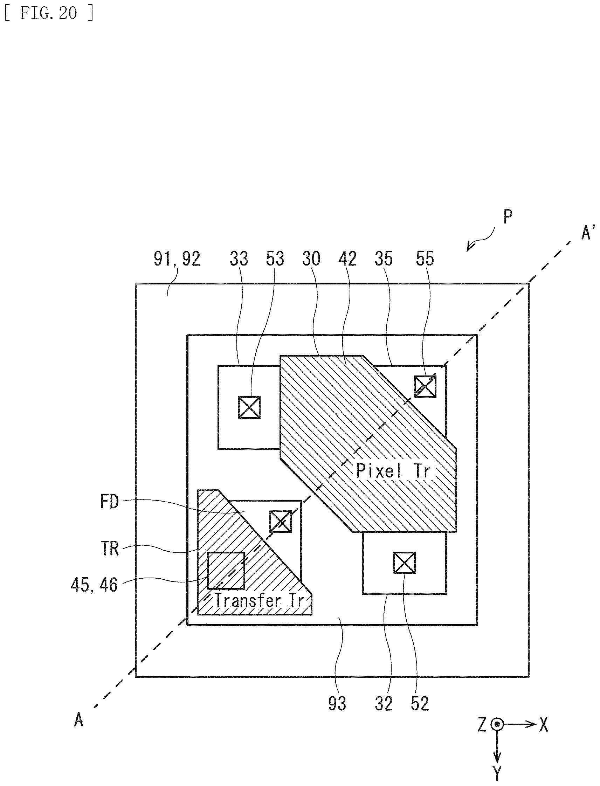

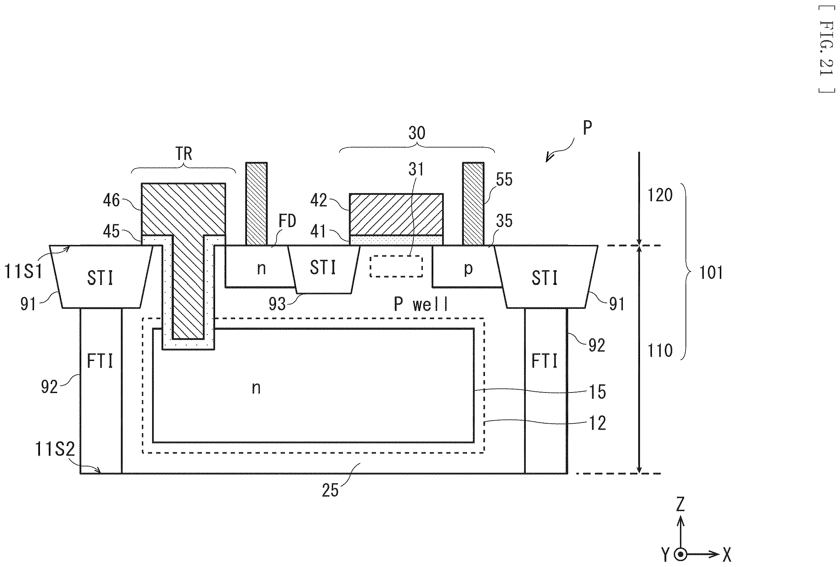

FIG. 20 is a diagram illustrating an example of a planar configuration of a pixel in an imaging device according to Modification Example 3. FIG. 21 is a diagram illustrating an example of a cross-sectional configuration of the pixel in the imaging device. FIG. 21 schematically illustrates an example of the configuration of the pixel in a direction along line A-A' illustrated in FIG. 20.

The semiconductor region 35 may be provided to be adjacent to at least one of the gate electrode 42 or the gate insulating film 41 in the pixel transistor 30 in the pixel P. In the examples illustrated in FIGs. 20 and 21, the semiconductor region 35 is disposed to be adjacent to the gate insulating film 41 and the gate electrode 42 of the pixel transistor 30, on the side of the first surface 11S1 of the semiconductor layer 110. It is to be noted that in the present disclosure, being "adjacent" includes a case of not having contact. Being "adjacent" includes a case of having a direct contact and a case of being adjacent to each other via a natural oxide film or the like.

In the present modification example, it is also possible for the imaging device 1 to have an advantageous configuration for miniaturization. Compared with a case where the semiconductor region 35 and the pixel transistor 30 are provided apart from each other, it is possible to increase an area of the region in which to dispose the transistor and the like in each pixel P. It is possible to increase the size of the pixel transistor 30 to be disposed in the pixel P, making it possible to improve a characteristic of the amplifying transistor AMP and the like in the reading circuit 20.

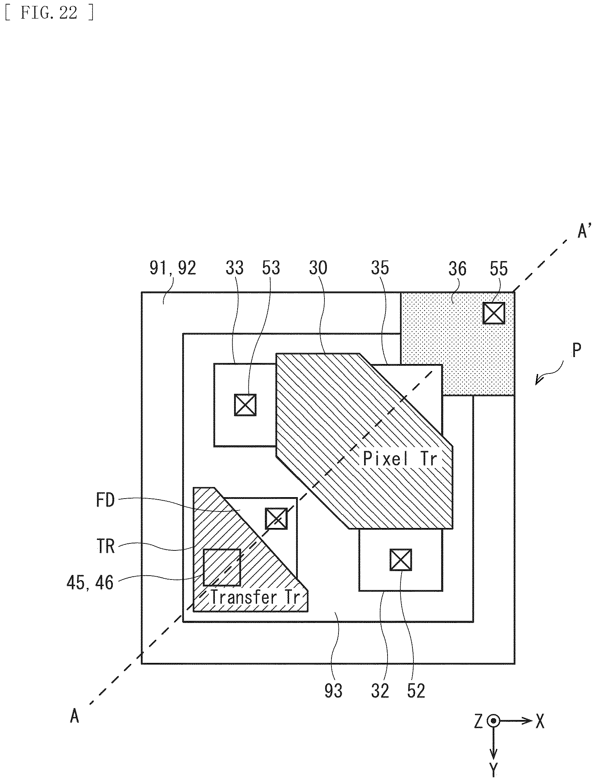

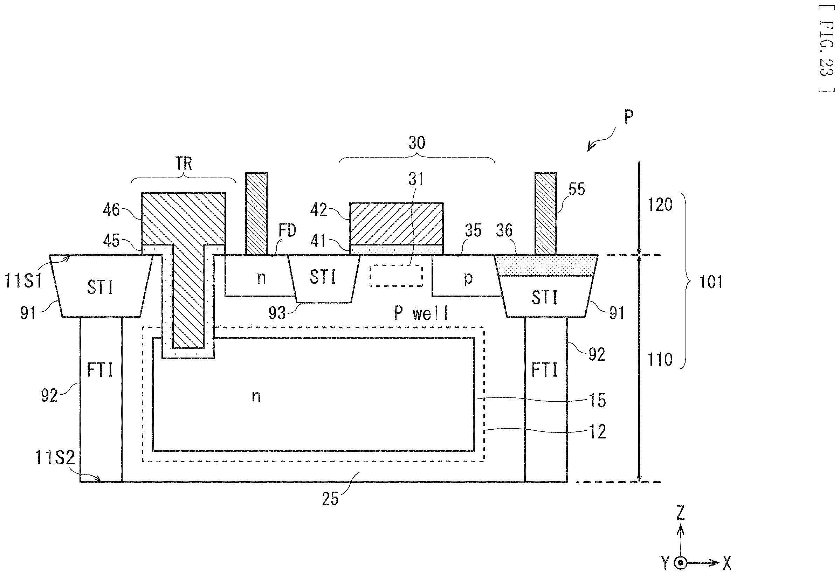

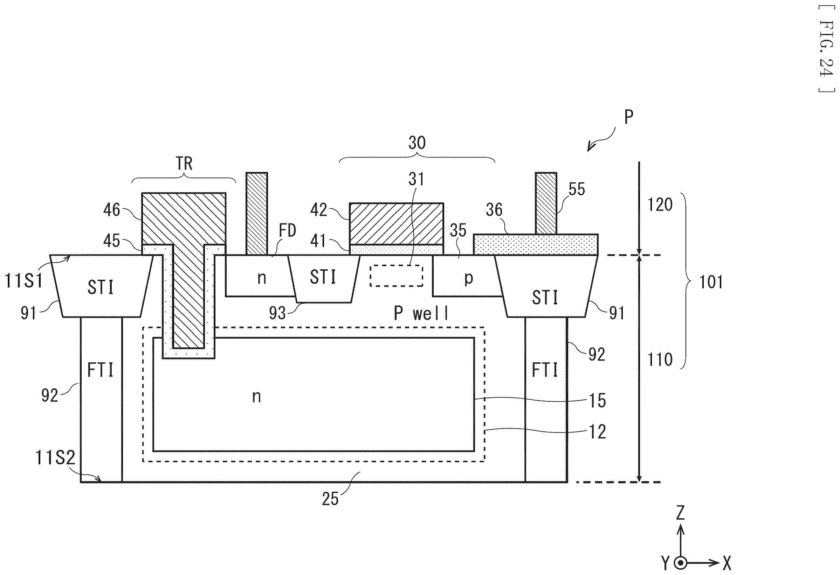

FIG. 22 is a diagram illustrating another example of the planar configuration of a pixel in the imaging device according to Modification Example 3. FIGs. 23 and 24 are diagrams illustrating another example of the cross-sectional configuration of the pixel in the imaging device. FIGs. 23 and 24 each schematically illustrate an example of the configuration of the pixel in a direction along line A-A' illustrated in FIG. 22. As illustrated in FIGs. 22 and 23, the imaging device 1 may include the conductor region 36 that electrically couples the contact 55 and the semiconductor region 35. It is to be noted that the conductor region 36 may be formed on the semiconductor layer 110 as in the example illustrated in FIG. 24. A portion of the conductor region 36 may be provided in the semiconductor layer 110.

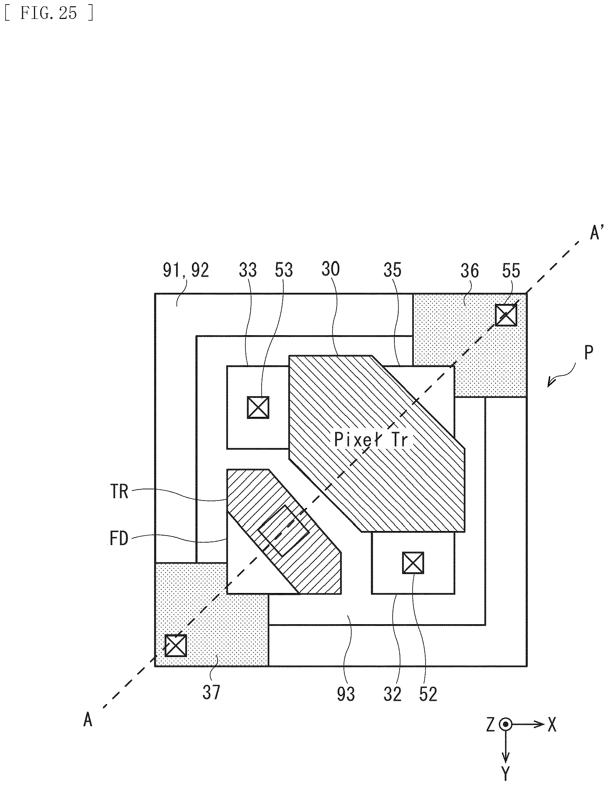

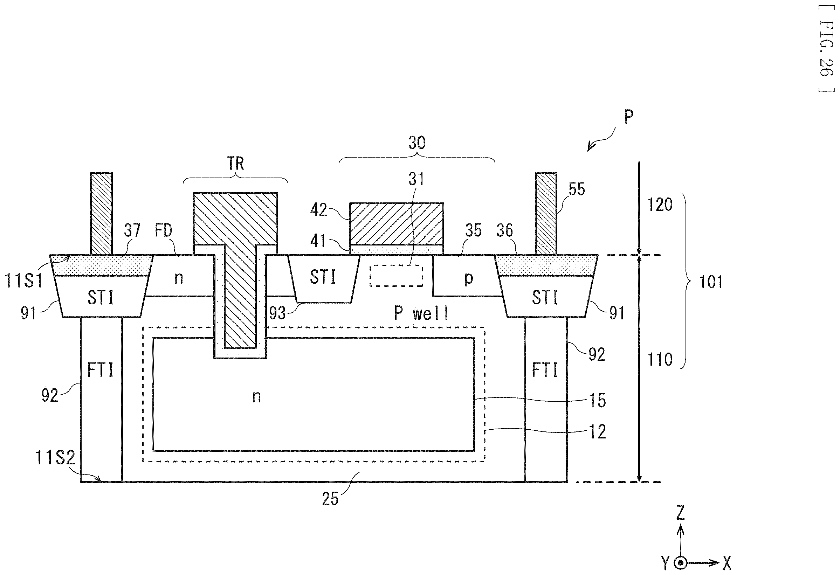

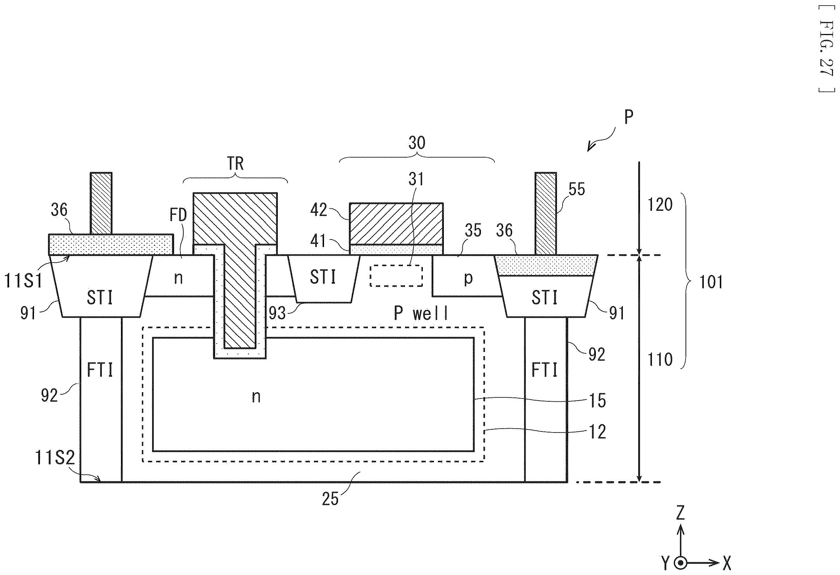

FIG. 25 is a diagram illustrating another example of the planar configuration of a pixel in the imaging device according to Modification Example 3. FIGs. 26 and 27 each describe another example of the cross-sectional configuration of the pixel in the imaging device. FIGs. 26 and 27 each schematically illustrate an example of the configuration of the pixel in a direction along line A-A' illustrated in FIG. 25. As illustrated in FIGs. 25 and 26, the imaging device 1 may include the semiconductor region 37 that electrically couples the floating diffusion FD in each of the plurality of pixels P. It is to be noted that the semiconductor region 37 may be formed on the semiconductor layer 110 as in the example illustrated in FIG. 27. A portion of the semiconductor region 37 may be provided in the semiconductor layer 110.

### (1-4. Modification Example 4)

In the embodiment described above, an example of the arrangement of transistors in the pixel P has been described, but the arrangement of the transistors is not limited to the examples described above. In addition, the configuration of the reading circuit 20 is not limited to the above examples and can be changed as appropriate.

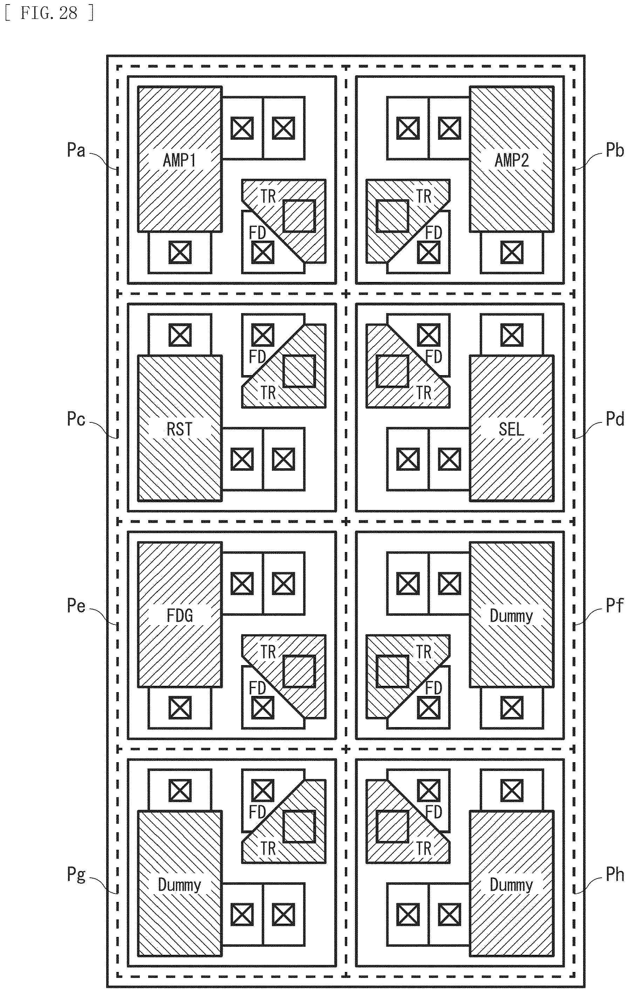

FIGs. 28 to 35 are diagrams describing an example of an arrangement of pixel transistors in an imaging device according to Modification Example 4. FIGs. 28 to 35 illustrate an example of a case where 2 × 4 pixels share one reading circuit 20. In FIGs. 28 to 35, the 2 × 4 pixels is illustrated, assuming the eight pixels P sharing the reading circuit 20 to be pixels Pa to Ph.

The reading circuit 20 may include a plurality of amplifying transistors AMP (amplifying transistors AMP1 to AMP6, and the like) coupled in parallel with each other. In addition, the reading circuit 20 may also include a plurality of selection transistors SEL (for example, a selection transistor SEL1 and a selection transistor SEL2) coupled in parallel with each other.

For example, in the example illustrated in FIG. 28, the amplifying transistor AMP1 is provided in the pixel Pa as the pixel transistor 30. In the pixel Pb, the amplifying transistor AMP2 is provided as the pixel transistor 30. In the pixel Pc, the reset transistor RST is provided as the pixel transistor 30. In addition, in the pixel Pd, the selection transistor SEL is provided as the pixel transistor 30.

In addition, in the example illustrated in FIG. 28, the transistor FDG is provided in the pixel Pe as the pixel transistor 30. In each of the pixels Pf to Ph, the dummy transistor is provided as the pixel transistor 30.

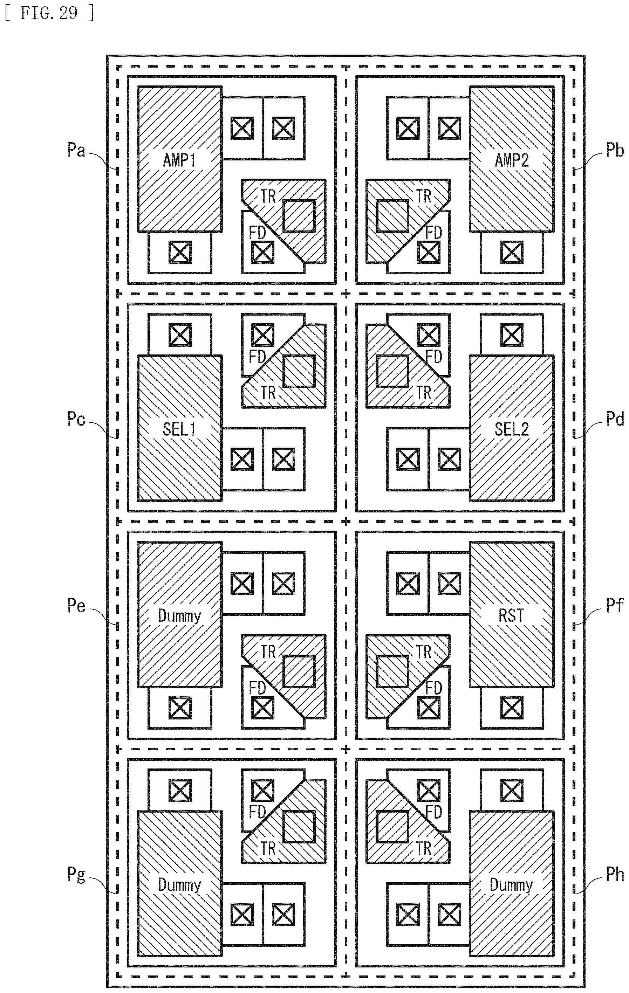

In the example illustrated in FIG. 29, the amplifying transistor AMP1 is provided in the pixel Pa as the pixel transistor 30. In the pixel Pb, the amplifying transistor AMP2 is provided as the pixel transistor 30. In the pixel Pc, the selection transistor SEL1 is provided as the pixel transistor 30. In addition, in the pixel Pd, the selection transistor SEL2 is provided as the pixel transistor 30.

In addition, in the example illustrated in FIG. 29, the dummy transistor is provided in each of the pixels Pe, Pg, and Ph as the pixel transistor 30. In the pixel Pf, the reset transistor RST is provided as the pixel transistor 30.

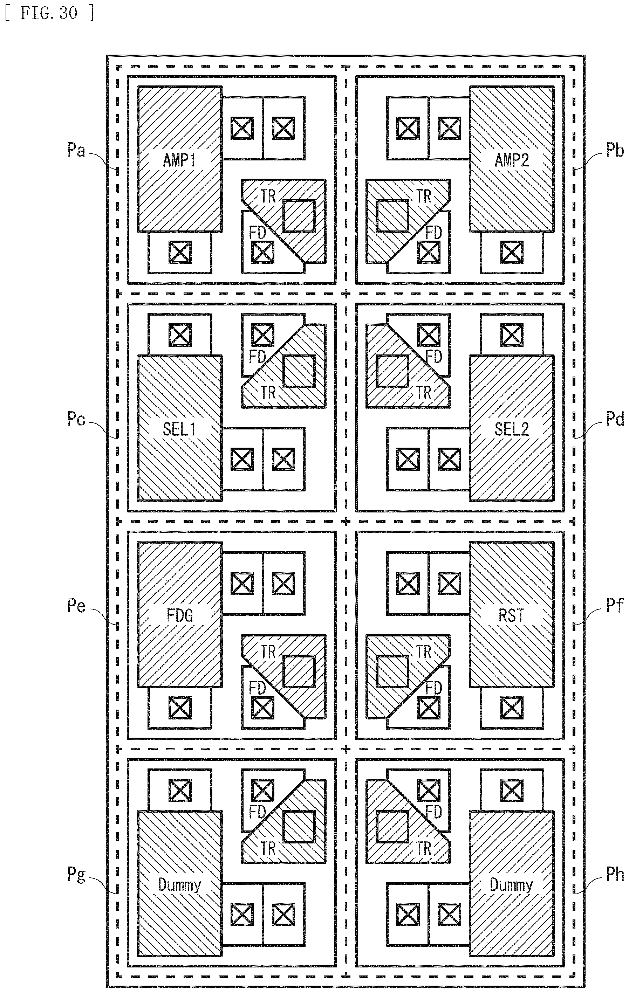

In the example illustrated in FIG. 30, the transistor FDG is provided in the pixel Pe as the pixel transistor 30. In the pixel Pf, the reset transistor RST is provided as the pixel transistor 30. In each of the pixels Pg and Ph, the dummy transistor is provided as the pixel transistor 30.

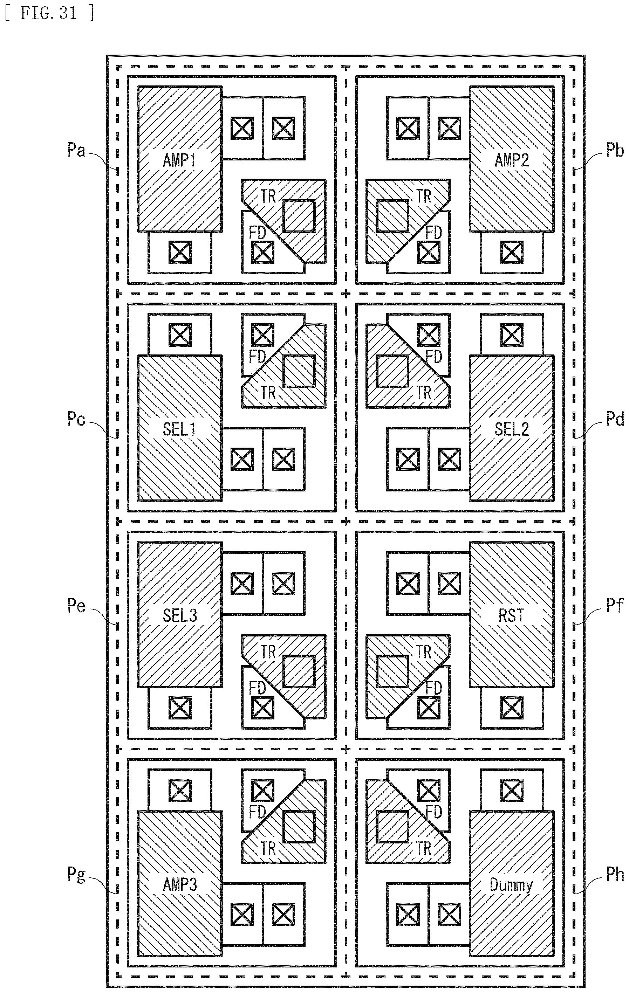

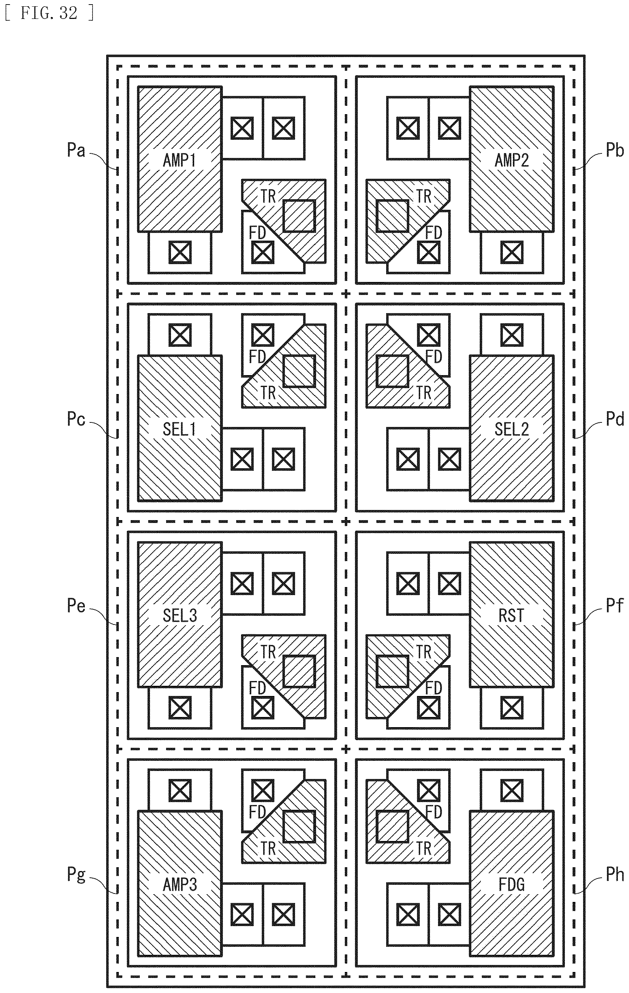

In the example illustrated in FIG. 31, a selection transistor SEL3 is provided in the pixel Pe as the pixel transistor 30. In the pixel Pf, the reset transistor RST is provided as the pixel transistor 30. In the pixel Pg, an amplifying transistor AMP3 is provided as the pixel transistor 30. In the pixel Ph, the dummy transistor is provided as the pixel transistor 30. It is to be noted that as illustrated in FIG. 32, the transistor FDG may be provided as the pixel transistor 30 in the pixel Ph.

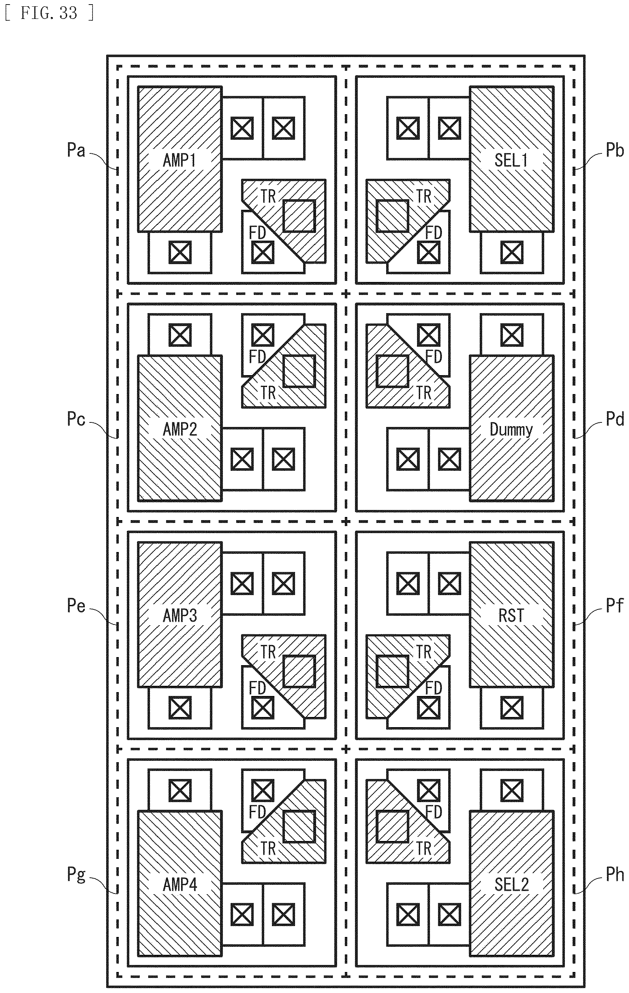

In the example illustrated in FIG. 33, the amplifying transistor AMP1 is provided in the pixel Pa as the pixel transistor 30. In the pixel Pb, the selection transistor SEL1 is provided as the pixel transistor 30. In the pixel Pc, the amplifying transistor AMP2 is provided as the pixel transistor 30. In addition, in the pixel Pd, the dummy transistor is provided as the pixel transistor 30.

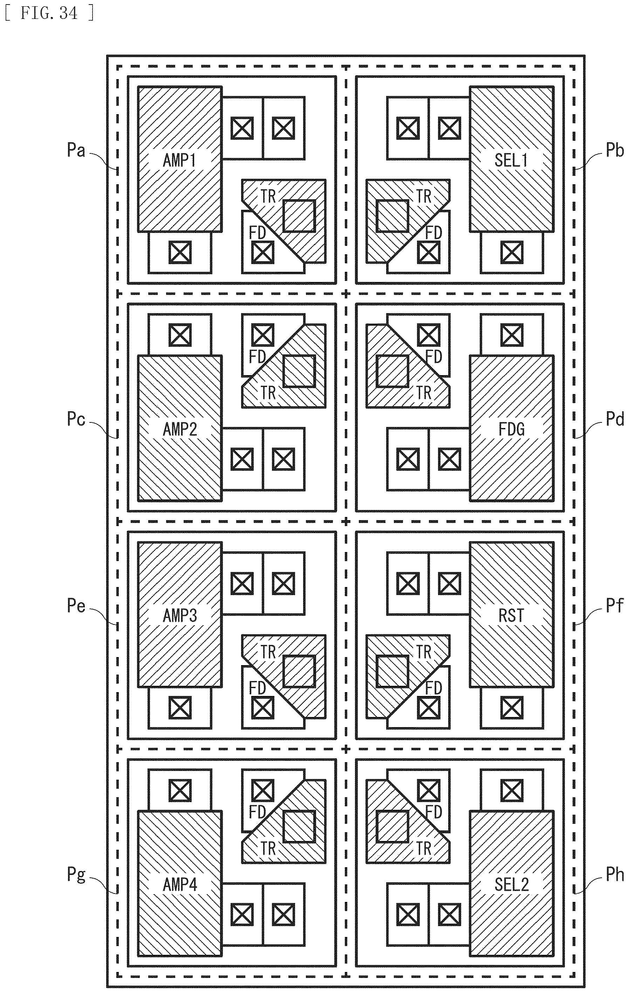

In addition, in the example illustrated in FIG. 33, the amplifying transistor AMP3 is provided in the pixel Pe as the pixel transistor 30. In the pixel Pf, the reset transistor RST is provided as the pixel transistor 30. In the pixel Pg, an amplifying transistor AMP4 is provided as the pixel transistor 30. In the pixel Ph, the selection transistor SEL2 is provided as the pixel transistor 30. It is to be noted that as illustrated in FIG. 34, the transistor FDG may be disposed in the pixel Pd as the pixel transistor 30.

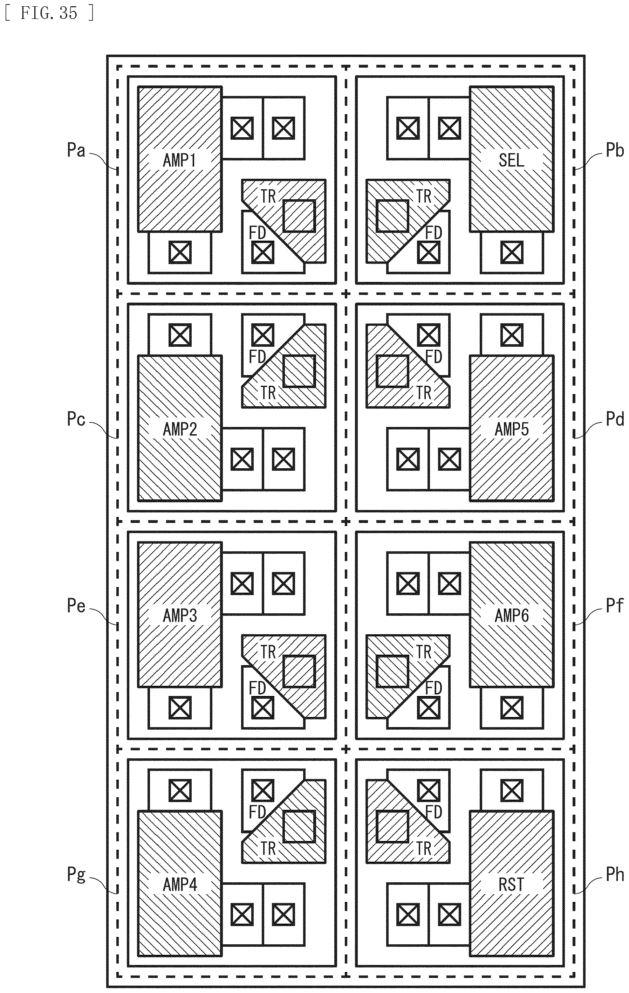

In the example illustrated in FIG. 35, the amplifying transistor AMP1 is provided in the pixel Pa as the pixel transistor 30. In the pixel Pb, the selection transistor SEL is provided as the pixel transistor 30. In the pixel Pc, the amplifying transistor AMP2 is provided as the pixel transistor 30. In addition, in the pixel Pd, an amplifying transistor AMP5 is provided as the pixel transistor 30.

In addition, in the example illustrated in FIG. 35, the amplifying transistor AMP3 is provided in the pixel Pe as the pixel transistor 30. In the pixel Pf, an amplifying transistor AMP6 is provided as the pixel transistor 30. In the pixel Pg, the amplifying transistor AMP4 is provided as the pixel transistor 30. In the pixel Ph, the reset transistor RST is provided as the pixel transistor 30.

### <2. Second Embodiment>

Next, a second embodiment of the present disclosure will be described. In the following, components similar to those in the above embodiment will be denoted by the same reference numerals, and the description thereof will be omitted as appropriate.

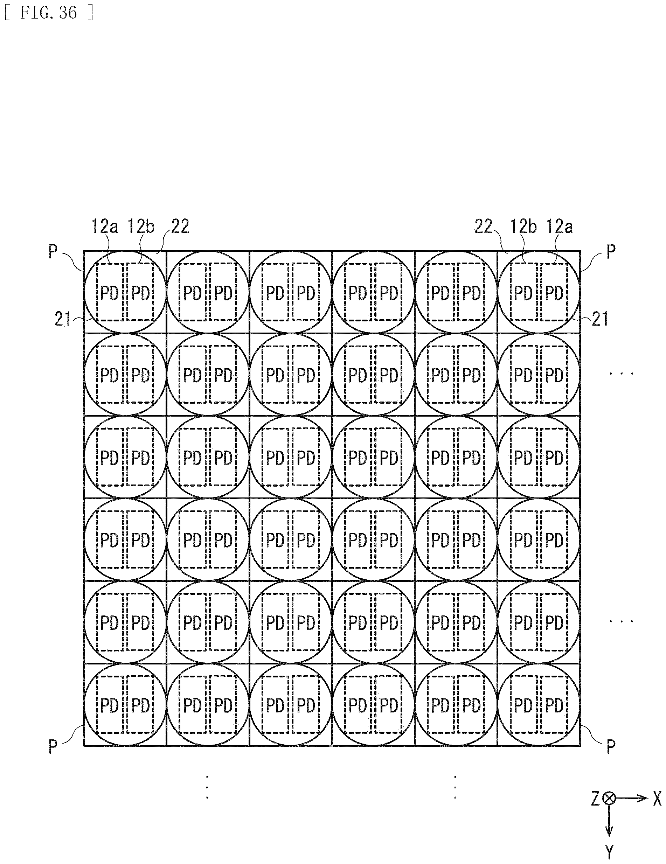

FIG. 36 is a diagram illustrating an example of an arrangement of pixels in an imaging device according to the second embodiment of the present disclosure. A pixel P in an imaging device 1 includes a plurality of photoelectric conversion sections 12 (in the example illustrated in FIG. 36, a photoelectric conversion section 12a and a photoelectric conversion section 12b). The photoelectric conversion section 12b is provided adjacent to the photoelectric conversion section 12a. It can also be said that the pixel including the photoelectric conversion section 12a and a pixel including the photoelectric conversion section 12b are provided.

In the present embodiment, one lens 21 (lens section) is provided for a plurality of photoelectric conversion sections 12, for example, two photoelectric conversion sections 12 (photoelectric conversion section 12a and photoelectric conversion section 12b). The photoelectric conversion section 12a and the photoelectric conversion section 12b each receive light passing through a region different from each other in an optical system such as an imaging lens and perform pupil division.

It is possible to obtain phase difference data (phase difference information) by using a first pixel signal based on electric charge photoelectrically converted by the photoelectric conversion section 12a and a second pixel signal based on electric charge photoelectrically converted by the photoelectric conversion section 12b. Using the phase difference data makes it possible to perform phase difference AF (Auto Focus).

The reading circuit 20 is configured to output the first pixel signal and the second pixel signal from each pixel P sharing the reading circuit 20. In addition, the reading circuit 20 may read a pixel signal corresponding to electric charge, which is obtained by adding the electric charge converted by the photoelectric conversion section 12a and the electric charge converted by the photoelectric conversion section 12b.

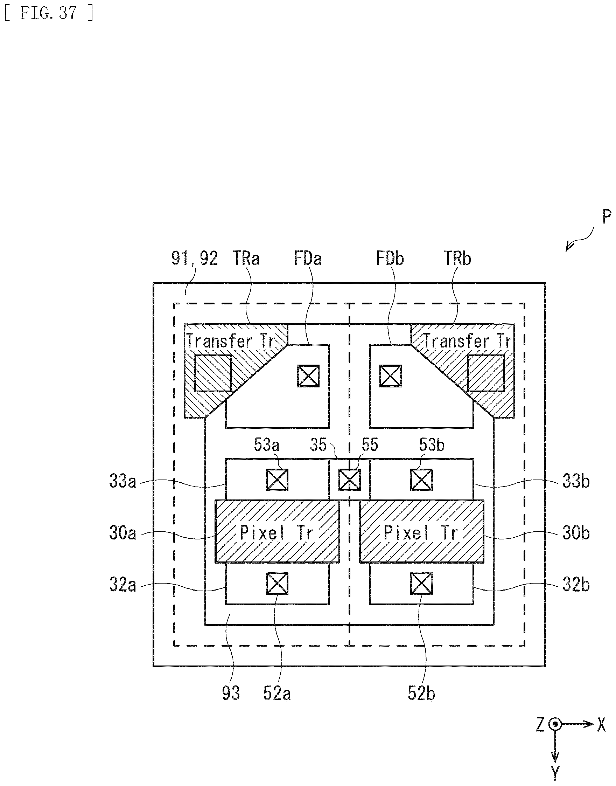

FIG. 37 is a diagram illustrating an example of a planar configuration of a pixel in the imaging device according to the second embodiment. The pixel P in the imaging device 1 includes transfer transistors TRa and TRb, floating diffusions FDa and FDb, pixel transistors 30a and 30b, and the semiconductor region 35.

The transfer transistor TRa is configured to transfer, to the floating diffusion FDa, the electric charge photoelectrically converted by the photoelectric conversion section 12a. The transfer transistor TRb is configured to transfer, to the floating diffusion FDb, the electric charge photoelectrically converted by the photoelectric conversion section 12b. The floating diffusion FDa may accumulate the electric charge photoelectrically converted by the photoelectric conversion section 12a. In addition, the floating diffusion FDb may accumulate the electric charge photoelectrically converted by the photoelectric conversion section 12b.

For example, the reading circuit 20 is configured to output the pixel signal based on the electric charge accumulated in the floating diffusion FDa, the pixel signal based on the electric charge accumulated in the floating diffusion FDb, and the like. In addition, for example, the reading circuit 20 is configured to output a pixel signal corresponding to electric charge, which is obtained by adding the electric charge accumulated in the floating diffusion FDa and the electric charge accumulated in the floating diffusion FDb.

For example, the pixel transistor 30a and the pixel transistor 30b are each a transistor in the reading circuit 20. A semiconductor region 32a and a semiconductor region 33a are a source region and a drain region of the pixel transistor 30a. One of the semiconductor regions 32a and 33a is the source region of the pixel transistor 30a, and another of the semiconductor regions 32a and 33a is the drain region of the pixel transistor 30a.

In addition, the semiconductor region 32b and the semiconductor region 33b are a source region and a drain region of the pixel transistor 30b. One of the semiconductor regions 32b and 33b is the source region of the pixel transistor 30b, and another of the semiconductor regions 32b and 33b is the drain region of the pixel transistor 30b.

Each of the pixel transistors 30a and 30b is used as an amplifying transistor AMP, a selection transistor SEL, a transistor FDG, a reset transistor RST, or the like. It is to be noted that the pixel transistor 30a or the pixel transistor 30b in a portion of the pixels P may be a dummy transistor. The reading circuit 20 may include a dummy transistor as the pixel transistor 30a or the pixel transistor 30b.

In the imaging device 1 according to the present embodiment, the semiconductor region 35 is provided in contact with the pixel transistor 30a and the pixel transistor 30b. For example, in the pixel P, the semiconductor region 35 is provided in contact with the source region or the drain region of the pixel transistor 30a and with the source region or the drain region of the pixel transistor 30b.

In the example illustrated in FIG. 37, the semiconductor region 35 is provided in contact with the semiconductor region 33a in the pixel transistor 30a and the semiconductor region 33b in the pixel transistor 30b. It is to be noted that the semiconductor region 35 may be provided adjacent to the semiconductor regions 32a and 32b. The semiconductor region 35 may be provided to be adjacent to the gate in each of the pixel transistors 30a and 30b.

In this manner, according to the present embodiment, the semiconductor region 35 is provided in contact with the pixel transistor 30a and the pixel transistor 30b. This allows the imaging device 1 to have an advantageous configuration for miniaturization. Compared with a case where the semiconductor region 35 is provided apart from the pixel transistors 30a and 30b, it is possible to increase an area of the region in which to dispose a transistor and the like in each pixel P. It becomes possible to increase the size of the transistor to be disposed in the pixel P.

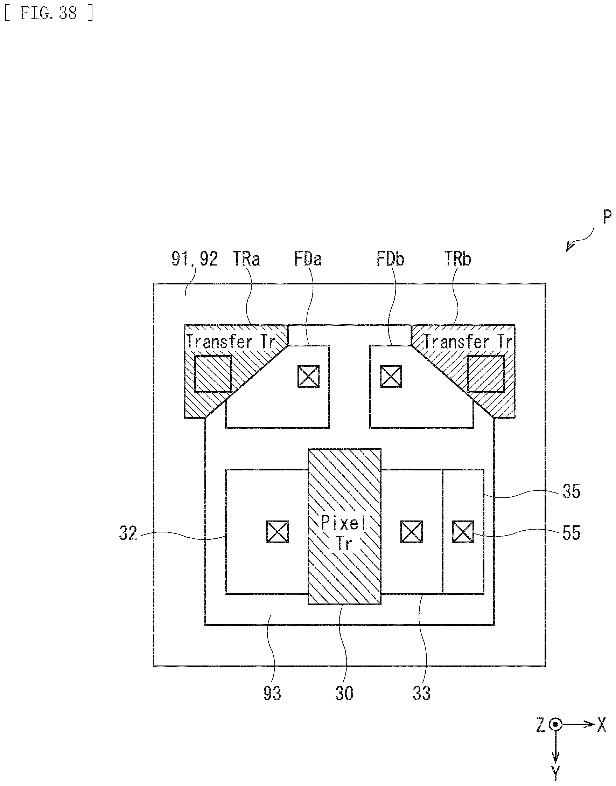

FIG. 38 is a diagram illustrating another example of the planar configuration of a pixel in the imaging device according to the second embodiment. As in the example illustrated in FIG. 38, one pixel transistor 30 may be provided for the photoelectric conversion sections 12a and 12b. For example, the pixel transistor 30 is a transistor in the reading circuit 20 and is provided for each pixel P. It is to be noted that the pixel transistor 30 in a portion of the pixels P may be a dummy transistor.

For example, the semiconductor region 35 is provided in contact with the source region or the drain region of the pixel transistor 30 in each pixel P. In the example illustrated in FIG. 38, the semiconductor region 35 is provided in contact with the semiconductor region 33 in the pixel transistor 30. In this case, it is also possible to increase the size of the transistor to be provided in the pixel P, making it possible to improve the characteristic of the amplifying transistor AMP and the like in the reading circuit 20.

It is particularly possible to increase the area efficiency in a fine pixel, and to increase the size of the pixel transistor 30. This makes it possible to improve the characteristic of the transistor in the reading circuit 20. It becomes possible to suppress deterioration of pixel signal quality, making it possible to suppress deterioration in image quality.

### [Workings and Effects]

A photodetector according to the present embodiment includes a semiconductor layer (semiconductor layer 110), a plurality of pixels each including a first pixel having a photoelectric conversion element, and trenches (trench 91 and trench 92). The first pixel includes a transistor (pixel transistor 30), a first semiconductor region of a first conductivity type (semiconductor region 35), and a first contact (contact 55). The first semiconductor region is in contact with the transistor. The photodetector has a lens (lens 21) that light enters. The photodetector includes, as the photoelectric conversion element, a first photoelectric conversion element (photoelectric conversion section 12a) that performs photoelectric conversion on the light transmitted through the lens and a second photoelectric conversion element (photoelectric conversion section 12b) that is provided adjacent to the first photoelectric conversion element and performs photoelectric conversion on the light transmitted through the lens.

In the photodetector (imaging device 1) according to the present embodiment, the semiconductor region 35 is in contact with the pixel transistor 30. This allows the imaging device 1 to have an advantageous configuration for pixel miniaturization. It is possible to increase the size of the pixel transistor, making it possible to improve a characteristic of the pixel transistor. It becomes possible to achieve a photodetector having an advantage for miniaturization.

Next, a modification example of the present disclosure will be described. In the following, components similar to those in the above embodiment will be denoted by the same reference numerals, and the description thereof will be omitted as appropriate.

### (2-1. Modification Example 5)

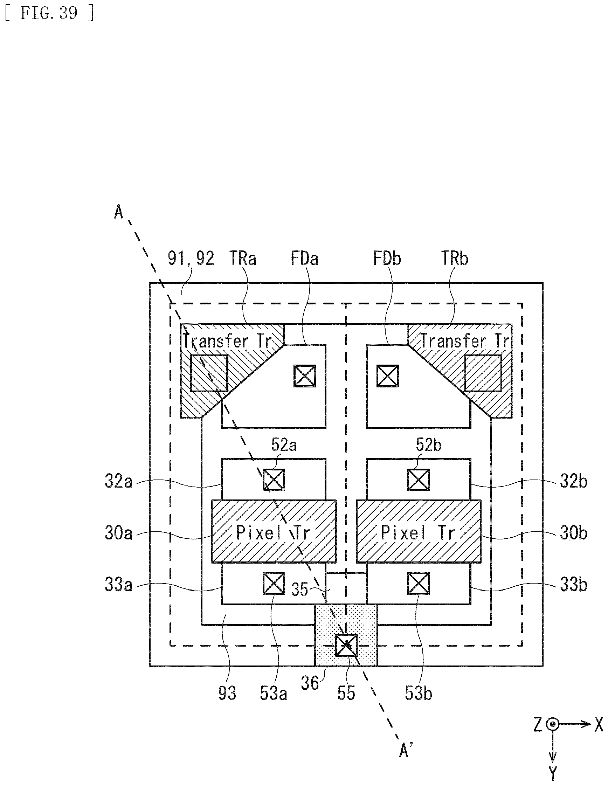

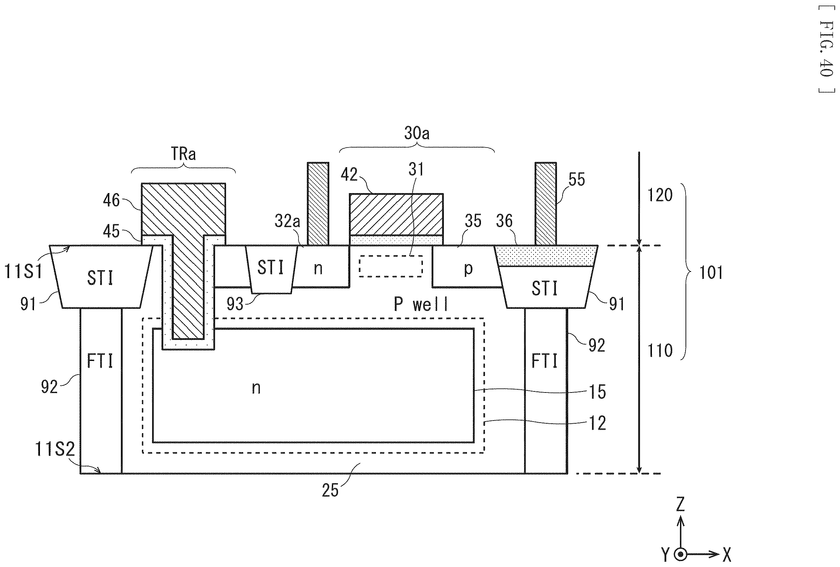

FIG. 39 is a diagram illustrating an example of a planar configuration of an imaging device according to Modification Example 5 of the present disclosure. FIG. 40 is a diagram describing an example of a cross-sectional configuration of the pixel in the imaging device. FIG. 40 schematically illustrates an example of the configuration of the pixel in a direction along line A-A' illustrated in FIG. 39.

The imaging device 1, as illustrated in FIGs. 39 and 40, may include a conductor region 36 that electrically couples the contact 55 and the semiconductor region 35. Via the conductor region 36, the contact 55 is electrically coupled to the semiconductor region 33a in the pixel transistor 30a and to the semiconductor region 33b in the pixel transistor 30b.

For example, the conductor region 36 is provided in the semiconductor layer 110. The conductor region 36, as an example, includes polysilicon doped with an impurity. It is to be noted that the conductor region 36 may include another conductive material.

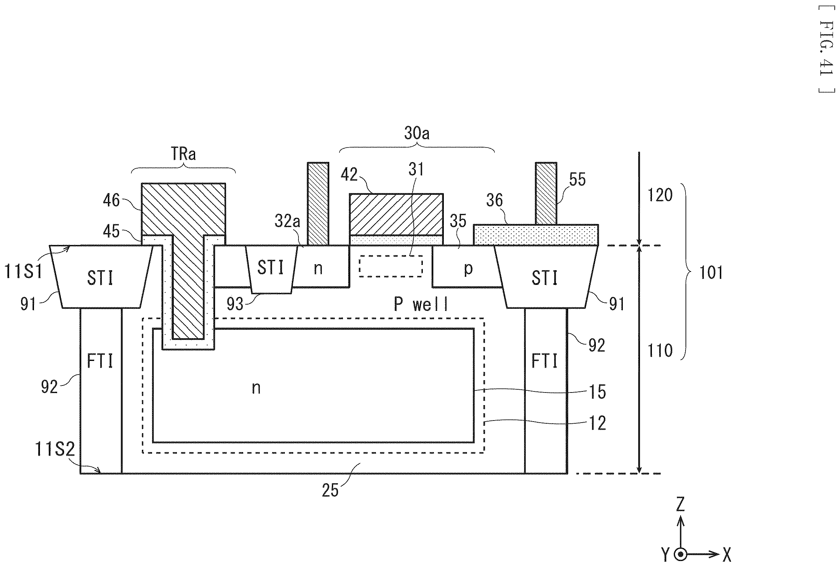

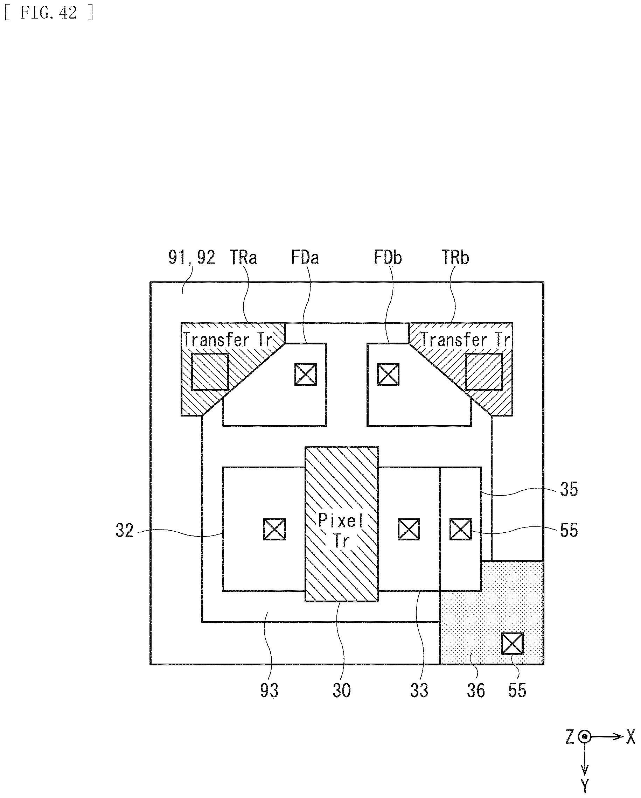

As in the example illustrated in FIG. 41, the conductor region 36 may be provided on the semiconductor layer 110. A portion of the conductor region 36 may be provided in the semiconductor layer 110. In addition, in the imaging device 1, one pixel transistor 30 and one conductor region 36 may be provided for each pixel P as in the example illustrated in FIG. 42.

For example, as in the case of the first embodiment, the conductor region 36 may be provided for a plurality of adjacent pixels P. The semiconductor region 33 in each of the plurality of pixels P is electrically coupled to each other via the conductor region 36 that is shared in common. It is to be noted that the semiconductor region 32 in each of the plurality of pixels P may be electrically coupled to each other via the conductor region 36 shared in common.

### (2-2. Modification Example 6)

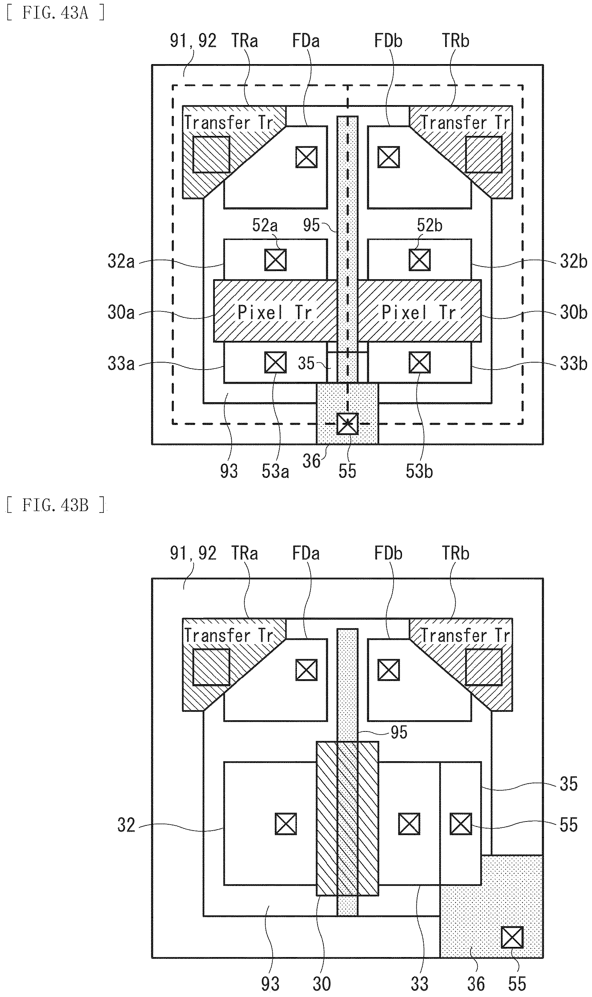

FIGs. 43A and 43B are diagrams describing a configuration of a pixel in an imaging device according to Modification Example 6. As in the example illustrated in FIGs. 43A and 43B, the imaging device 1 may include a separator 95. The separator 95 includes, for example, a trench. The separator 95 is provided between the photoelectric conversion section 12a and the photoelectric conversion section 12b in the semiconductor layer 110. It is to be noted that the separator 95 may include an insulating material or may include a semiconductor region formed by ion implantation. The separator 95 may include a p-type semiconductor region or an n-type semiconductor region.

### (2-3. Modification Example 7)

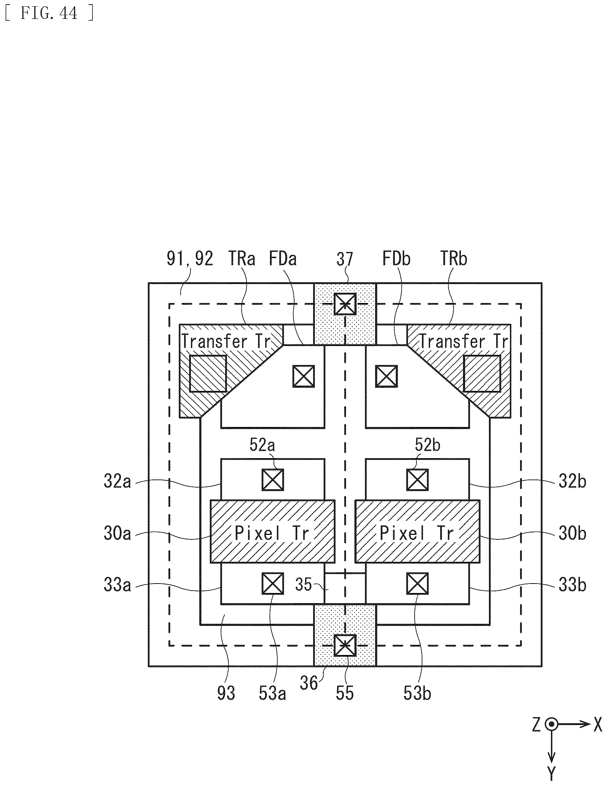

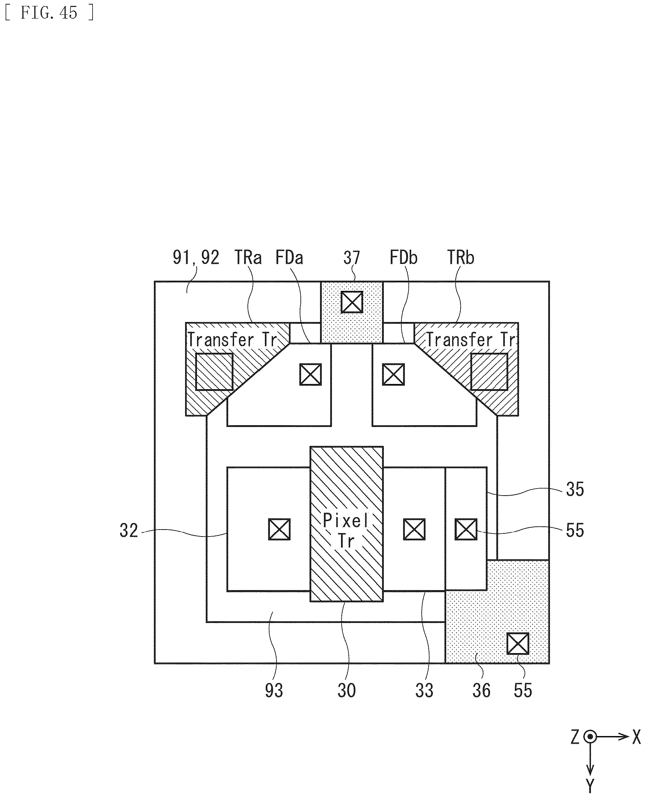

FIGs. 44 and 45 are diagrams illustrating an example of a planar configuration of a pixel in an imaging device according to Modification Example 7. As illustrated in FIG. 44 or FIG. 45, the imaging device 1 may include the semiconductor region 37 that electrically couples a plurality of floating diffusions FD. For example, the floating diffusion FDa and the floating diffusion FDb are electrically coupled to each other via the semiconductor region 37.

For example, the semiconductor region 37 is provided in the semiconductor layer 110. The semiconductor region 37, as an example, includes polysilicon doped with an impurity. It is to be noted that the semiconductor region 37 may include another conductive material. The semiconductor region 37 may be provided on the semiconductor layer 110. A portion of the semiconductor region 37 may be provided in the semiconductor layer 110.

In addition, as in the case of the first embodiment, the semiconductor region 37 may be provided for a plurality of adjacent pixels P. The floating diffusion FD in each of the plurality of pixels P may be electrically coupled to each other via the semiconductor region 37 shared in common.

### (2-4. Modification Example 8)

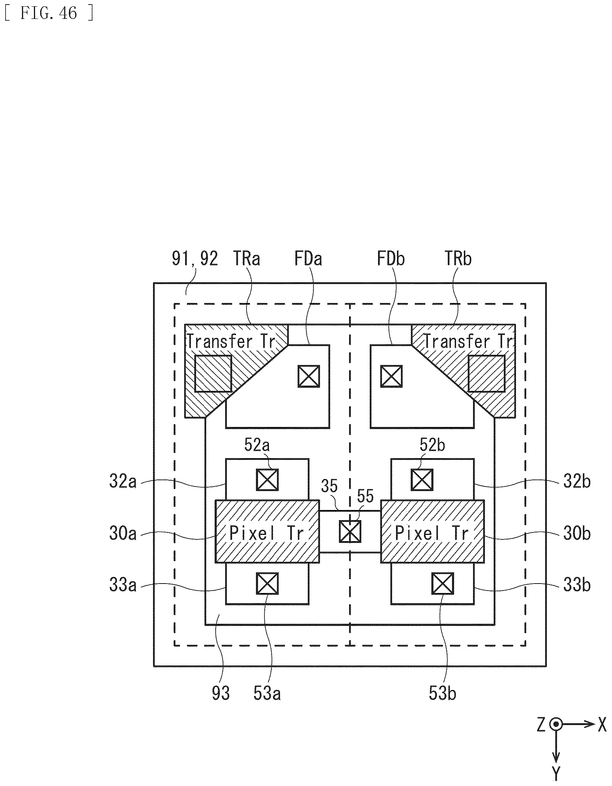

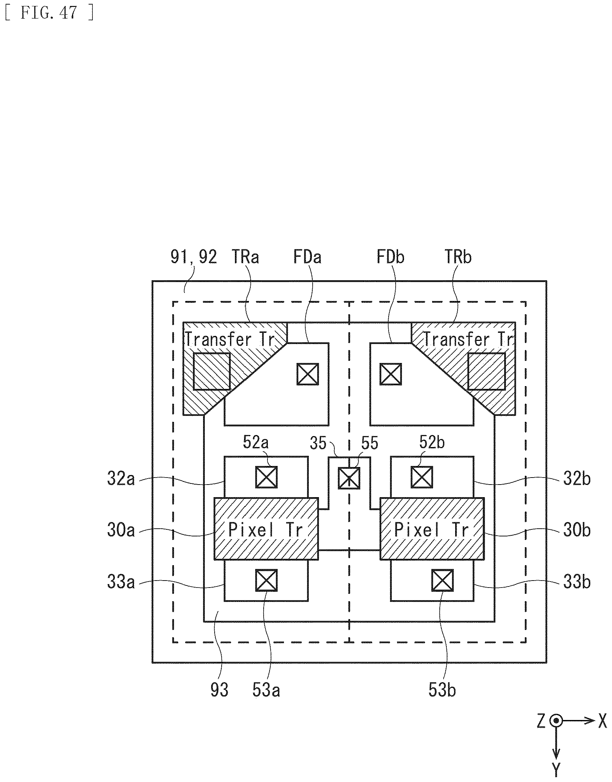

FIGs. 46 and 47 are diagrams each illustrating an example of a planar configuration of a pixel in an imaging device according to Modification Example 8. In each pixel P, the semiconductor region 35 may be provided to be adjacent to at least one of the gate electrode or the gate insulating film in each of the plurality of adjacent pixel transistors. For example, the semiconductor region 35 on the side of the first surface 11S1 of the semiconductor layer 110 may be provided to be adjacent to at least one of the gate electrode or the gate insulation film in each of the pixel transistors 30a and 30b.

As in the examples illustrated in FIG. 46 or FIG. 47, the semiconductor region 35 is provided to be adjacent to at least one of the gate electrode or the gate insulating film in the pixel transistor 30a and to at least one of the gate electrode or the gate insulating film in the pixel transistor 30b. This allows the imaging device 1 to have an advantageous configuration for miniaturization.

In the present modification example, compared with a case where the semiconductor region 35 and the pixel transistor 30 are provided apart from each other, it is possible to increase an area of a region in which to dispose a transistor and the like in the pixel P. It is possible to increase the size of the transistor to be provided in each pixel P, making it possible to improve the characteristic of the amplifying transistor AMP and the like in the reading circuit 20.

In addition, as illustrated in FIG. 47, the semiconductor region 35 may be provided between the semiconductor region 32a that is the source region or the drain region of the pixel transistor 30a and with the semiconductor region 32b that is the source region or the drain region of the pixel transistor 30b. This makes it possible to secure a distance between the contact 55 and the channel region in each of the pixel transistors 30a and 30b.

Providing the contact 55 apart (away) from the channel region makes it possible to prevent a negative influence on the pixel transistors 30a and 30b. It becomes possible to suppress deterioration of the characteristic of the pixel transistors 30a and 30b. It becomes possible to suppress mixing of noise into a pixel signal, and suppress accuracy degradation in phase difference detection. In addition, it is expected to suppress deterioration in image quality. Furthermore, providing the contact 55 apart from the channel layer also allows for a lower impurity concentration near a portion in which the channel region and the semiconductor region 35 are in contact with each other. This allows for a design to reduce generation of an intense electric field.

### (2-5. Modification Example 9)

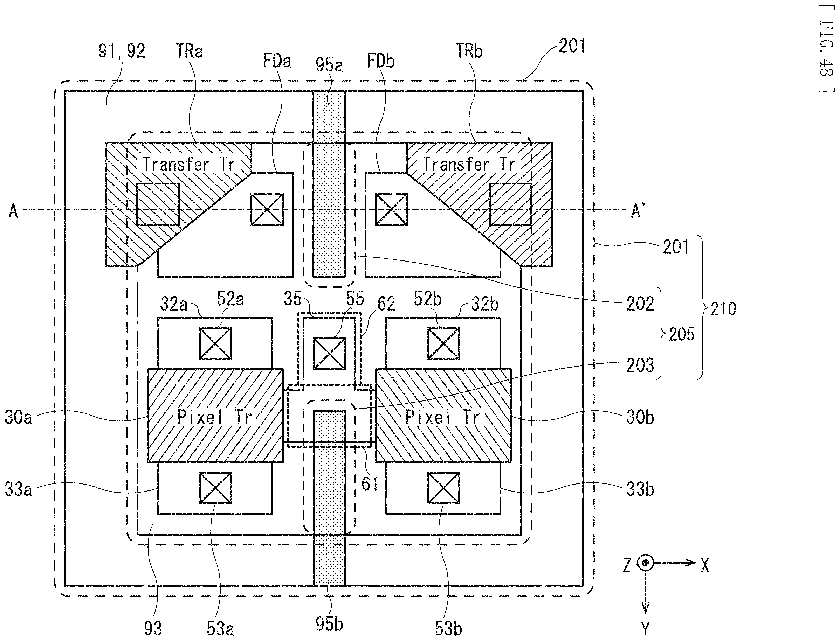

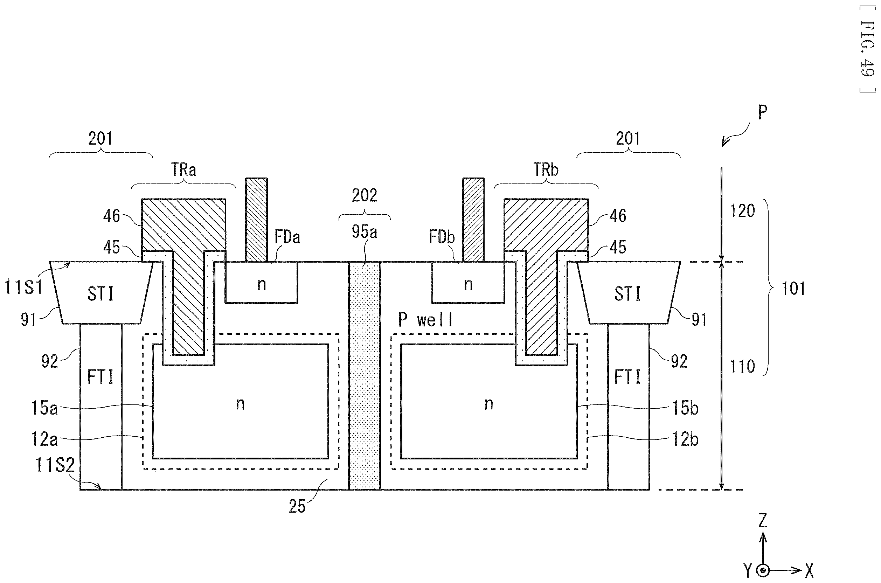

FIG. 48 is a diagram describing an example of a planar configuration of a pixel in an imaging device according to Modification Example 9. FIG. 49 is a diagram describing an example of a cross-sectional configuration of the pixel in the imaging device. FIG. 49 illustrates an example of the configuration of the pixel in a direction along line A-A' illustrated in FIG. 48. As illustrated in FIG. 48, the imaging device 1 has a trench 210 that is provided in a region 201 and a region 205.

For example, the trench 210 includes the above-described trenches 91 and 92, a separator 95a, a separator 95b, and the like. Each of the separator 95a and the separator 95b has a similar configuration to the configuration of the above-described separator 95, and includes a trench. All or a part of the trenches 91 and 92, the separator 95a, and the separator 95b may be integrally included as the trench 210.

The region 201 is a region including the trenches 91 and 92 and separates a pixel from an adjacent pixel. The region 205, as illustrated in FIG. 48, includes a region 202 having the separator 95a and a region 203 having the separator 95b. In the region 202 and the region 203, the separators 95a and 95b are provided to shield the photoelectric conversion section 12a and the photoelectric conversion section 12b in a plan view.

The separator 95a is provided between a plurality of adjacent floating diffusions FD and a plurality of adjacent photoelectric conversion sections 12. In the example illustrated in FIGs. 48 and 49, the separator 95a is provided between the floating diffusion FDa and the floating diffusion FDb, and between the photoelectric conversion section 12a and the photoelectric conversion section 12b.

The separator 95b is provided between a plurality of adjacent pixel transistors 30 and a plurality of adjacent photoelectric conversion sections 12. In the examples illustrated in FIGs. 48 and 49, the separator 95b is formed between the transistor 30a and the transistor 30b, and between the photoelectric conversion section 12a and the photoelectric conversion section 12b.

As illustrated in FIG. 48, the semiconductor region 35 is provided between the separator 95a and the separator 95b in a plan view. The semiconductor region 35 includes a first part 61 and a second part 62. In a plan view, the first part 61 is in contact with the pixel transistor 30a and the pixel transistor 30b in a horizontal direction (X-axis direction).

In addition, the second part 62 is in contact with the first part 61 in a vertical direction (Y-axis direction). The contact 55 is provided in the second part 62 of the semiconductor region 35. The contact 55 is provided on the second part 62. For example, the first part 61 has an impurity concentration lower than the impurity concentration of the second part 62.

The semiconductor region 35 is provided to be adjacent to at least one of the gate insulating film or the gate electrode in the pixel transistor 30a and to be adjacent to at least one of the gate insulating film or the gate electrode in the pixel transistor 30b. This allows the imaging device 1 to have an advantageous configuration for miniaturization.

The semiconductor region 35 is located between the separator 95a and the separator 95b, and the contact 55 is provided apart from the channel region in each of the pixel transistors 30a and 30b. This makes it possible to suppress mixing of noise into the pixel signal, and suppress accuracy degradation in phase difference detection. In addition, it is expected to suppress deterioration in image quality. Furthermore, providing the contact 55 apart from the channel layer also allows for a lower impurity concentration near a part in which the channel region and the semiconductor region 35 are in contact with each other. This allows for a design to reduce generation of an intense electric field.

In addition, as described above, the first part 61 has an impurity concentration lower than the impurity concentration of the second part 62 coupled to the contact 55. Providing the first part 61 having a lower impurity concentration makes it possible to suppress generation of an intense electric field between the first part 61 in the semiconductor region 35 and the channel region. This makes it possible to suppress noise mixed into the image signal.

The photodetector according to the present modification example includes a first pixel (pixel P) provided in a semiconductor layer, and a trench (trench 210) including a first region (region 201) that separates the first pixel from an adjacent pixel and a second region (region 205 including region 203 and 203) in which the photoelectric conversion element provided in the first pixel is shielded in a plan view. The second region (region 202) includes, in a plan view, a first separator (separator 95a) between a first floating diffusion region and a second floating diffusion region that are provided in the first pixel. The second region (region 203) includes, in a plan view, a second separator (separator 95b) between a first transistor and a second transistor that are provided in the first pixel. The first pixel includes a first semiconductor region of a first conductivity type (semiconductor region 35) and a first contact (contact 55) that is electrically coupled to the first semiconductor region. In a plan view, the first semiconductor region is provided between the first separator and the second separator. The first semiconductor region is in contact with the first transistor and the second transistor.

In the photodetector (imaging device 1) according to the present embodiment, the semiconductor region 35 is in contact with the pixel transistors 30a and 30b. This allows the imaging device 1 to have an advantageous configuration for pixel miniaturization. It is possible to increase the size of the pixel transistor, making it possible to improve a characteristic of the pixel transistor. It is possible to achieve a photodetector having an advantage for miniaturization.

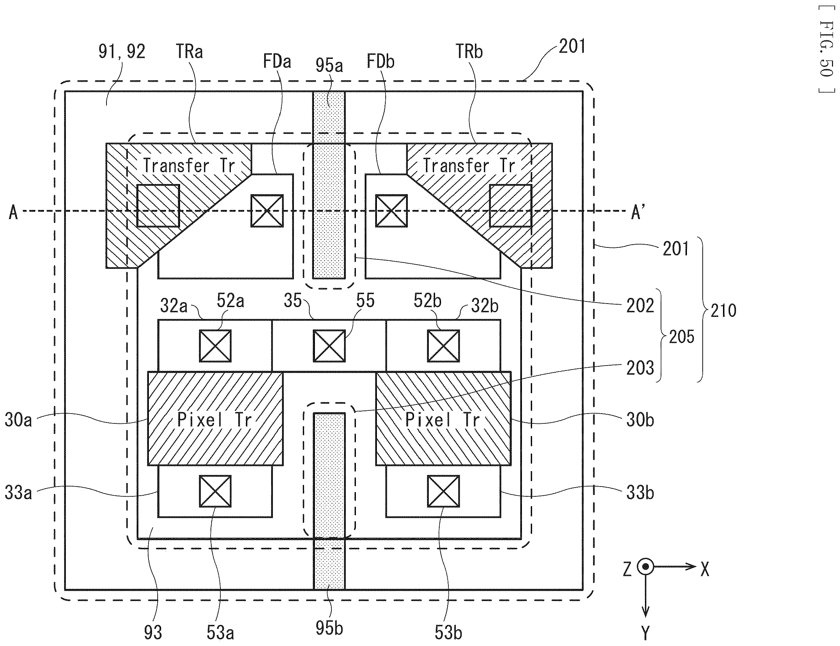

It is to be noted that as illustrated in FIG. 50, the semiconductor region 35 may be provided in contact with the semiconductor region 32a that is the source region or the drain region of the pixel transistor 30a and with the semiconductor region 32b that is the source region or the drain region of the pixel transistor 30b. In addition, the semiconductor region 35 may be provided in contact with the semiconductor region 33a in the pixel transistor 30a and with the semiconductor region 33b in the pixel transistor 30b.

### (2-6. Modification Example 10)

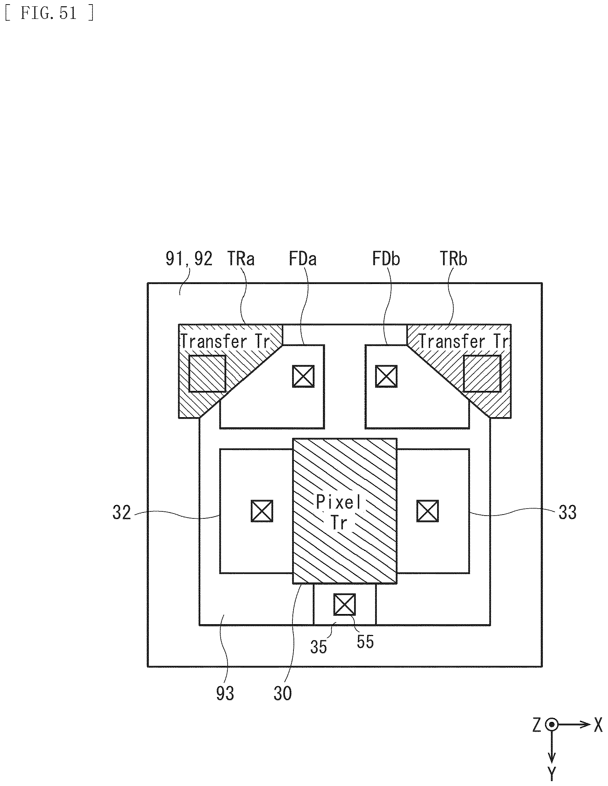

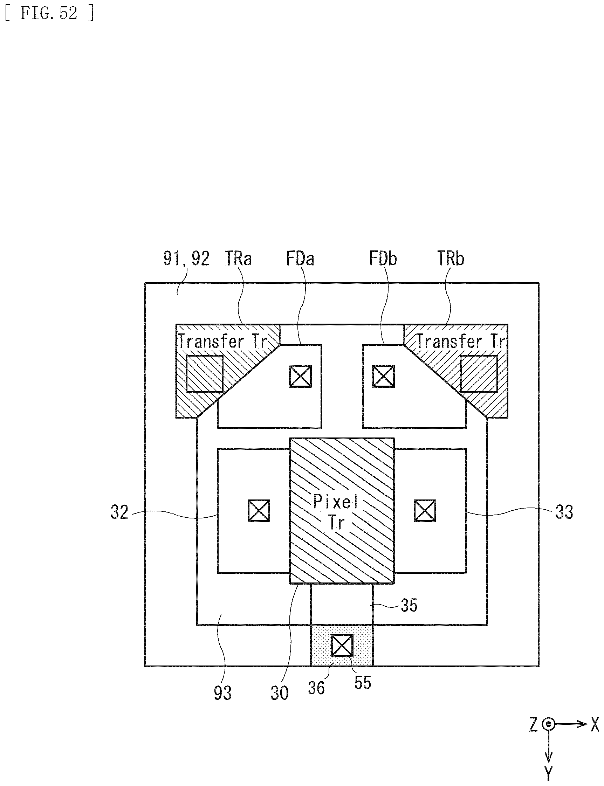

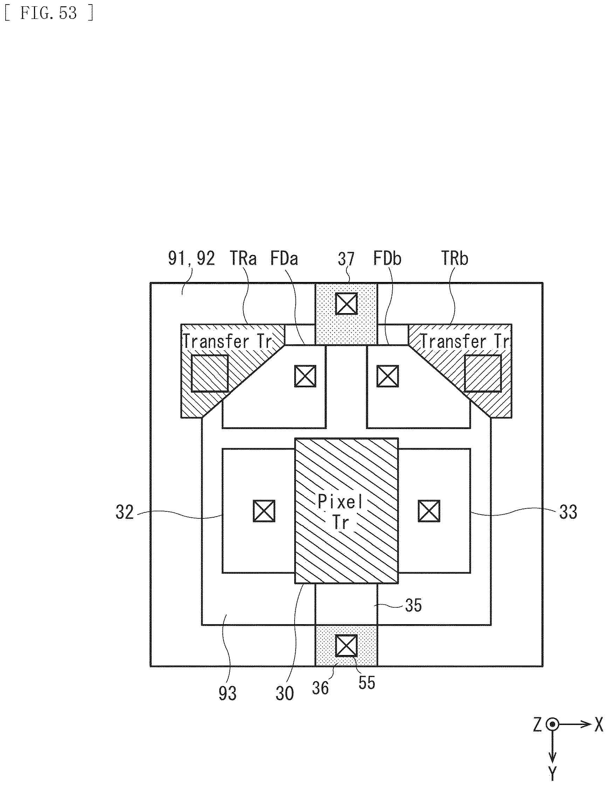

FIGs. 51 to 53 are diagrams illustrating an example of a planar configuration of an imaging device according to Modification Example 10. Each pixel P in the imaging device 1 may have a configuration as illustrated in FIG. 51. One pixel transistor 30 and one semiconductor region 35 may be provided for the photoelectric conversion sections 12a and 12b. In addition, as illustrated in FIG. 52, the imaging device 1 may have the conductor region 36 that electrically couples the contact 55 and the semiconductor region 35. As in the example illustrated in FIG. 53, the imaging device 1 may include the semiconductor region 37 that electrically couples a plurality of floating diffusions FD.

### <3. Application Example>

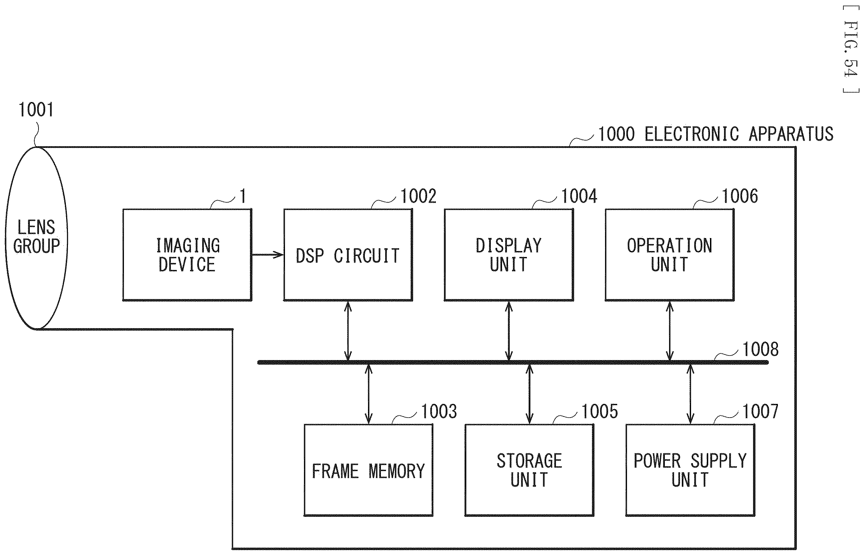

It is possible to apply the above imaging device 1 and the like to any type of electronic apparatus equipped with an imaging function, for example, a camera system such as a digital still camera and a video camera, a cell phone with an imaging function, and the like. FIG. 54 illustrates a schematic configuration of an electronic apparatus 1000.

The electronic apparatus 1000 includes, for example, a lens group 1001, an imaging device 1, a DSP (Digital Signal Processor) circuit 1002, a frame memory 1003, a display unit 1004, a recording unit 1005, an operation unit 1006, and a power supply unit 1007, which are coupled to each other via a bus line 1008.

The lens group 1001 captures entering light (image light) from a subject to form an image on an imaging surface of the imaging device 1. The imaging device 1 converts a light amount of the entering light, which is formed into the image on the imaging surface by the lens group 1001, into an electrical signal on a pixel-by-pixel basis and supplies the electrical signal to the DSP circuit 1002 as a pixel signal.

The DSP circuit 1002 is a signal processing circuit that processes a signal supplied from the imaging device 1. The DSP circuit 1002 outputs image data that is obtained by processing the signal from the imaging device 1. The frame memory 1003 temporarily holds the image data processed by the DSP circuit 1002 on a frame-by-frame basis.

For example, the display unit 1004 includes a panel-type display such as a liquid crystal panel or an organic EL (Electro Luminescence) panel and records video or still image data captured by the imaging device 1 on a recording medium such as semiconductor memory or a hard disk.

The operation unit 1006 outputs an operation signal regarding various functions of the electronic apparatus 1000 in accordance with user operation. The power supply unit 1007 supplies various power sources that are to be an operating power source for the DSP circuit 1002, the frame memory 1003, the display unit 1004, the recording unit 1005, and the operation unit 1006, to these supply targets as appropriate.

### <4. Practical Application Examples>

### (Practical Application Example to Mobile body)

The technique according to the present disclosure (the present technique) is applicable to various products. For example, the technique according to the present disclosure may be realized as a device mounted on any type of mobile body from among an automobile, an electric vehicle, a hybrid electric vehicle, a motorcycle, a bicycle, a personal mobility, an airplane, a drone, a vessel, a robot, or the like.

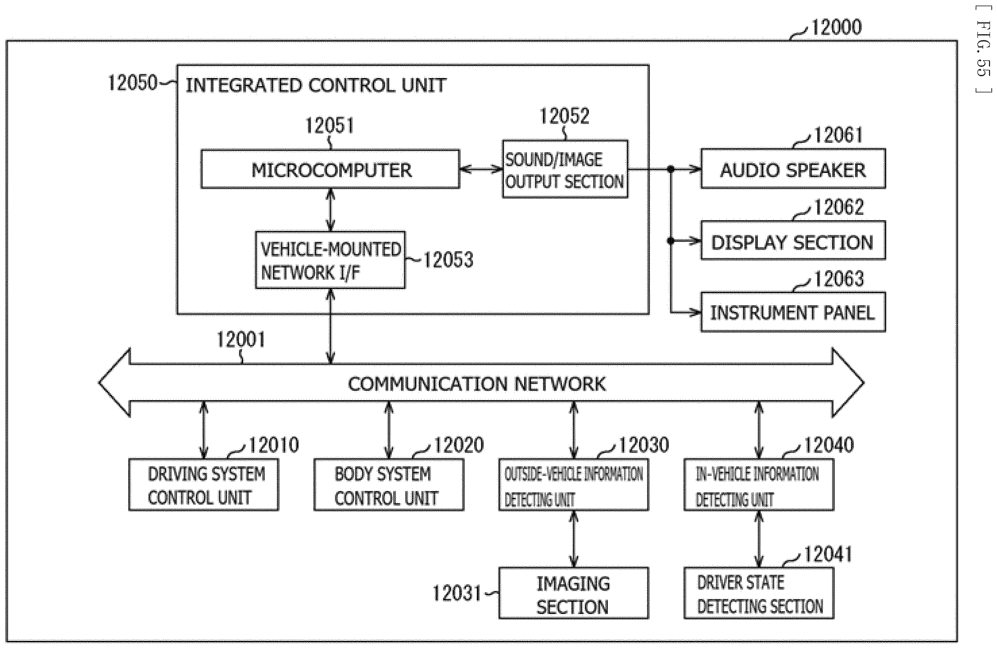

FIG. 55 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 55, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 55, an audio speaker 12061, a display section 12062, and an instrument panel 12063 are illustrated as the output device. The display section 12062 may, for example, include at least one of an on-board display and a head-up display.

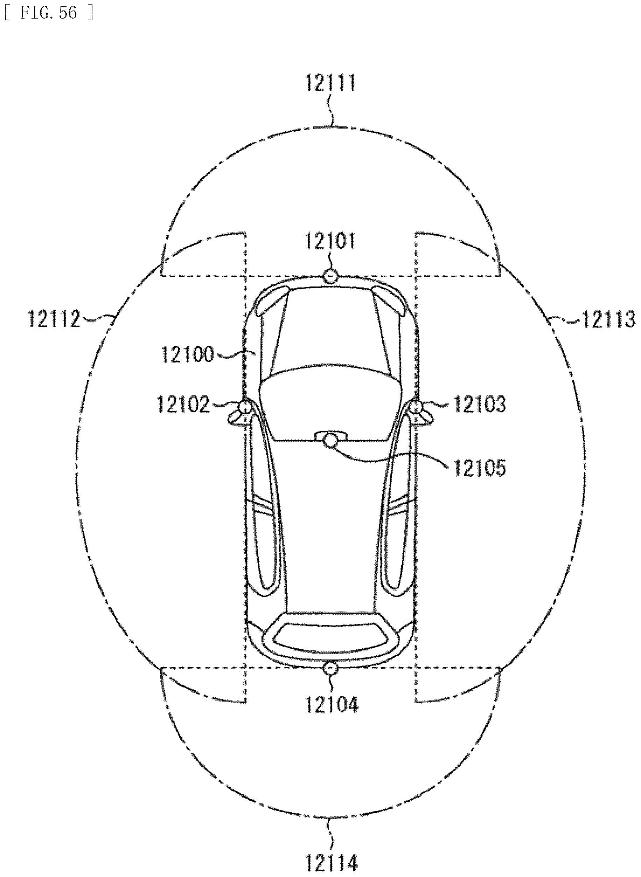

FIG. 56 is a diagram depicting an example of the installation position of the imaging section 12031.

In FIG. 56, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 56 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

An example of the mobile body control system to which the technique according to the present disclosure is applicable has been described above. Of the above described configuration, for example, the technique according to the present disclosure is applicable to the imaging section 12031. Specifically, for example, the imaging device 1 or the like is applicable to the imaging section 12031. Application of the technique according to the present disclosure to the imaging section 12031 makes it possible to obtain a high-resolution captured image. It becomes possible to perform high-precision control using a captured image in the mobile body control system.

### (Practical Application Example to Endoscopic Surgery System)

The technique according to the present disclosure (the present technique) is applicable to various products. For example, the technique according to the present disclosure may be applied to an endoscopic surgery system.

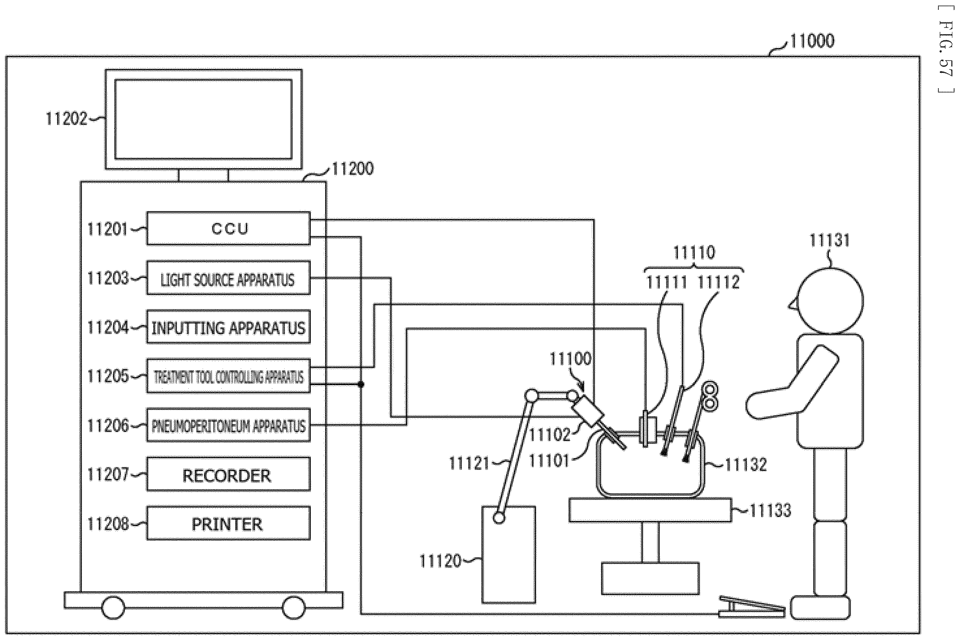

FIG. 57 is a view depicting an example of a schematic configuration of an endoscopic surgery system to which the technology according to an embodiment of the present disclosure (present technology) can be applied.

In FIG. 57, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy device 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body cavity of the patient 11132, and a camera head 11102 connected to a proximal end of the lens barrel 11101. In the example depicted, the endoscope 11100 is depicted which includes as a rigid endoscope having the lens barrel 11101 of the hard type. However, the endoscope 11100 may otherwise be included as a flexible endoscope having the lens barrel 11101 of the flexible type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body cavity of the patient 11132 through the objective lens. It is to be noted that the endoscope 11100 may be a forward-viewing endoscope or may be an oblique-viewing endoscope or a side-viewing endoscope.

An optical system and an image pickup element are provided in the inside of the camera head 11102 such that reflected light (observation light) from the observation target is condensed on the image pickup element by the optical system. The observation light is photo-electrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy device 11112 for cautery or incision of a tissue, sealing of a blood vessel or the like. A pneumoperitoneum apparatus 11206 feeds gas into a body cavity of the patient 11132 through the pneumoperitoneum tube 11111 to inflate the body cavity in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrow-band light and/or excitation light suitable for special light observation as described above.

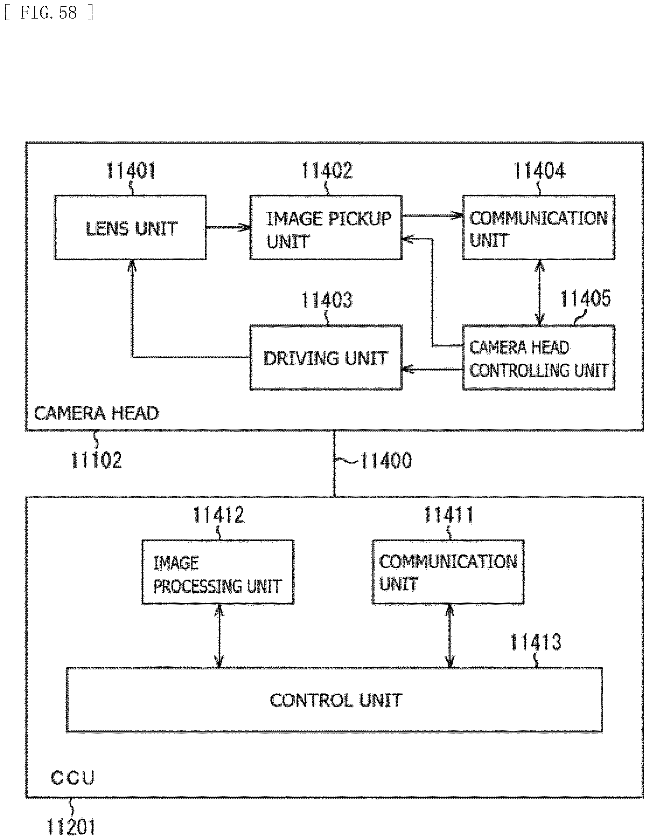

FIG. 58 is a block diagram depicting an example of a functional configuration of the camera head 11102 and the CCU 11201 depicted in FIG. 57.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy device 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

One example of the endoscopic surgery system to which the technique according to the present disclosure is applicable has been descried above. Of the configurations described above, for example, the technique according to the present disclosure is preferably applicable to the image pickup unit 11402 provided in the camera head 11102 of the endoscope 11100. It becomes possible to provide the high-precision endoscope 11100 by applying the technique according to the present disclosure to the image pickup unit 11402.

The technique according to the present disclosure has been described above with reference to some embodiments and the modification examples. However, the technique according to the present disclosure is not limited to the above-described embodiments and the like, and is modifiable in a variety of ways. For example, the modification examples described above have been described as the modification examples of the embodiment above, but it is possible to combine the configurations of various modifications as appropriate. For example, the present disclosure is not limited to a back-illuminated image sensor but is also applicable to a front-illuminated image sensor.

The above embodiments and examples have been described with reference to an imaging device as an example, but it is sufficient that the photodetector of the present disclosure receives entering light and converts the light into electric charge. The signal to be outputted may be a signal of image information or a signal of ranging information. The photodetector (imaging device) is applicable to an image sensor, a ranging sensor, and the like.

The photodetector according to the present disclosure is also applicable as a ranging sensor that allows for distance measurement by a TOF (Time of Flight) system. The photodetector (imaging device) is also applicable as a sensor that is able to detect an event, for example, an event-driven sensor (that is referred to as EVS (Event Vision Sensor), EDS (Event Driven Sensor), DVS (Dynamic Vision Sensor (DVS), or the like).

The photodetector according to one embodiment of the present disclosure includes a semiconductor layer, a plurality of pixels including a first pixel having a photoelectric conversion element provided in the semiconductor layer, and a trench provided between a plurality of adjacent pixels in the semiconductor layer. The first pixel includes a transistor provided on a first surface side of the semiconductor layer, a first semiconductor region of a first conductivity type, which is provided on the first surface side of the semiconductor layer, and a first contact that is electrically coupled to the first semiconductor region. The first semiconductor region is in contact with the transistor. This allows the photodetector to have an advantageous configuration for pixel miniaturization. It becomes possible to realize a photodetector having an advantage in miniaturization.

It is to be noted that effects described herein are merely illustrative and are not limitative, and may have other effects. In addition, it is to be noted that the technology may have the following configurations.
(1) A photodetector, including:
   a semiconductor layer;
   a plurality of pixels including a first pixel, the first pixel including a photoelectric conversion element provided in the semiconductor layer; and
   a trench provided between the plurality of pixels in the semiconductor layer, the plurality of pixels being adjacent to each other, in which
   the first pixel includes a transistor, a first semiconductor region, and a first contact, the transistor being provided on a side of a first surface of the semiconductor layer, the first semiconductor region having a first conductivity type and being provided on the side of the first surface of the semiconductor layer, and the first contact being electrically coupled to the first semiconductor region, and
   the first semiconductor region is in contact with the transistor.
(2) The photodetector according to (1), in which
   the transistor includes a source region and a drain region, the source region and the drain region having a second conductivity type and being provided in the semiconductor layer, and
   the first semiconductor region is in contact with the source region or the drain region in the transistor.
(3) The photodetector according to (1) or (2), in which
   the first semiconductor region includes a p-type semiconductor region, and
   the source region and the drain region each include an n-type semiconductor region.
(4) The photodetector according to any one of (1) to (3), in which
   the transistor includes a gate electrode and a gate insulating film, and
   the first semiconductor region is provided to be adjacent to at least one of the gate electrode or the gate insulating film in the transistor.
(5) The photodetector according to any one of (1) to (4), including a first well, the first well having the first conductivity type and being provided in the semiconductor layer, in which
   the first semiconductor region is provided in the first well, and
   the first contact is electrically coupled to the first well via the first semiconductor region.
(6) The photodetector according to any one of (1) to (5), including a conductor region, the conductor region being in contact with a portion of the first semiconductor region and being provided inside the trench, in which
   the first contact is provided on the conductor region, the first contact being electrically coupled to the first semiconductor region via the conductor region.
(7) The photodetector according to (6), in which the conductor region is provided in the semiconductor layer.
(8) The photodetector according to any one of (1) to (7), in which
   the plurality of pixels includes a second pixel adjacent to the first pixel, and
   the first pixel and the second pixel each include the photoelectric conversion element, a floating diffusion, the transistor, and the first semiconductor region.
(9) The photodetector according to (8), including a conductor region, the conductor region electrically coupling the first semiconductor region in the first pixel and the first semiconductor region in the second pixel.
(10) The photodetector according to (8) or (9), including:
   a second semiconductor region, the second semiconductor region electrically coupling the floating diffusion in the first pixel and the floating diffusion in the second pixel; and
   a second contact that is electrically coupled to the second semiconductor region.
(11) The photodetector according to any one of (1) to (10), including a reading circuit, the reading circuit including the transistor and being configured to output a signal, the signal being based on electric charge that is photoelectrically converted by the photoelectric conversion element.
(12) The photodetector according to (11), in which the transistor includes an amplifying transistor, a selection transistor, a reset transistor, a switching transistor, or a dummy transistor.
(13) The photodetector according to any one of (1) to (12), including:
   a lens that light enters; and
   a first photoelectric conversion element and a second photoelectric conversion element provided adjacent to the first photoelectric conversion element, the first photoelectric conversion element performing photoelectric conversion on the light transmitted through the lens, the second photoelectric conversion element performing photoelectric conversion on the light transmitted through the lens, the first photoelectric conversion element and the second photoelectric conversion element each being provided as the photoelectric conversion element.
(14) The photodetector according to (13), including:
   a first transistor; and
   a second transistor provided adjacent to the first transistor,
   the first transistor and the second transistor each being provided as the transistor, in which
   the first semiconductor region is in contact with the first transistor and the second transistor.
(15) The photodetector according to (14), in which
   the first transistor is provided on a side of the first photoelectric conversion element, the first transistor including a source region and a drain region each having a second conductivity type,
   the second transistor is provided on a side of the second photoelectric conversion element, the second transistor including a source region and a drain region each having the second conductivity type, and
   the first semiconductor region is in contact with the source region or the drain region in the first transistor, and with the source region or the drain region in the second transistor.
(16) The photodetector according to (14) or (15), in which
   the first transistor and the second transistor each include a gate electrode and a gate insulating film, and
   the first semiconductor region is provided to be adjacent to at least one of the gate electrode or the gate insulating film in the first transistor, and to at least one of the gate electrode or the gate insulating film in the second transistor.
(17) The photodetector according to any one of (14) to (16), in which
   the first contact is provided between a source region or a drain region in the first transistor and a source region or a drain region in the second transistor.
(18) The photodetector according to any one of (14) to (17), including a reading circuit, the reading circuit including the first transistor and the second transistor and being configured to output a signal based on electric charge photoelectrically converted by the first photoelectric conversion element and a signal based on electric charge photoelectrically converted by the second photoelectric conversion element.
(19) The photodetector according to any one of (13) to (18), in which the lens is provided on a side of a second surface of the semiconductor layer, the side of the second surface being opposite to the first surface.
(20) A photodetector, including:
   a first pixel provided in a semiconductor layer; and
   a trench including a first region and a second region, the first region separating the first pixel and an adjacent pixel, and the second region being a region in which a photoelectric conversion element provided in the first pixel is shielded in a plan view, in which
   the second region, in the plan view, includes a first separator between a first floating diffusion region and a second floating diffusion region, the first floating diffusion region and the second floating diffusion region being provided in the first pixel,
   the second region, in the plan view, includes a second separator between a first transistor and a second transistor, the first transistor and the second transistor being provided in the first pixel,
   the first pixel includes a first semiconductor region and a first contact, the first semiconductor region having a first conductivity type, and the first contact being electrically coupled to the first semiconductor region,
   the first semiconductor region is provided between the first separator and the second separator in the plan view, and
   the first semiconductor region is in contact with the first transistor and the second transistor.
(21) The photodetector according to (20), in which
   the first transistor and the second transistor each include a gate electrode and a gate insulating film, and
   the first semiconductor region is provided to be adjacent to at least one of the gate electrode or the gate insulating film.
(22) The photodetector according to (20) or (21), in which the first semiconductor region, in the plan view, includes a first part and a second part, the first part being in contact with the first transistor and the second transistor in a horizontal direction, and the second part being in contact with the first part in a vertical direction.
(23) The photodetector according to (22), in which the first contact is provided on the second part of the first semiconductor region.
(24) The photodetector according to (22) or (23), in which the first part has an impurity concentration lower than an impurity concentration of the second part.
(25) The photodetector according to (20), in which
   the first transistor and the second transistor each include a source region and a drain region, the source region and the drain region being provided in the semiconductor layer and each having a second conductivity type, and
   the first semiconductor region is in contact with the source region or the drain region in each of the first transistor and the second transistor.
(26) The photodetector according to (25), in which
   the first semiconductor region includes a p-type semiconductor region, and
   the source region and the drain region each include an n-type semiconductor region.
(27) An electronic apparatus, including:
   an optical system; and
   a photodetector that receives light transmitted through the optical system,
   the photodetector including
   a semiconductor layer,
   a plurality of pixels including a first pixel, the first pixel including a photoelectric conversion element provided in the semiconductor layer, and
   a trench provided between the plurality of pixels in the semiconductor layer, the plurality of pixels being adjacent to each other, in which
   the first pixel includes a transistor, a first semiconductor region, and a first contact, the transistor being provided on a side of a first surface of the semiconductor layer, the first semiconductor region having a first conductivity type and being provided on the side of the first surface of the semiconductor layer, and the first contact being electrically coupled to the first semiconductor region, and
   the first semiconductor region is in contact with the transistor.
(28) An electronic apparatus, including:
   an optical system; and
   a photodetector that receives light transmitted through the optical system,
   the photodetector including
   a first pixel provided in a semiconductor layer, and
   a trench including a first region and a second region, the first region separating the first pixel and an adjacent pixel, and the second region being a region in which a photoelectric conversion element provided in the first pixel is shielded in a plan view, in which
   the second region, in the plan view, includes a first separator between a first floating diffusion region and a second floating diffusion region, the first floating diffusion region and the second floating diffusion region being provided in the first pixel,
   the second region, in the plan view, includes a second separator between a first transistor and a second transistor, the first transistor and the second transistor being provided in the first pixel,
   the first pixel includes a first semiconductor region and a first contact, the first semiconductor region having a first conductivity type and the first contact being electrically coupled to the first semiconductor region,
   the first semiconductor region is provided between the first separator and the second separator in the plan view, and
   the first semiconductor region is in contact with the first transistor and the second transistor.

This application claims the benefit of United States Provisional Patent Application No. 63/310267 filed with the United States Patent and Trademark Office on February 15, 2022, the entire contents of which are incorporated herein by reference.

It should be understood by those skilled in the art that various modifications, combinations, sub-combinations, and alterations may occur depending on design requirements and other factors insofar as they are within the scope of the appended claims or the equivalents thereof.

## Claims

1. A photodetector, comprising:
a semiconductor layer;
a plurality of pixels including a first pixel, the first pixel including a photoelectric conversion element provided in the semiconductor layer; and
a trench provided between the plurality of pixels in the semiconductor layer, the plurality of pixels being adjacent to each other, wherein
the first pixel includes a transistor, a first semiconductor region, and a first contact, the transistor being provided on a side of a first surface of the semiconductor layer, the first semiconductor region having a first conductivity type and being provided on the side of the first surface of the semiconductor layer, and the first contact being electrically coupled to the first semiconductor region, and
the first semiconductor region is in contact with the transistor.

2. The photodetector according to claim 1, wherein
the transistor includes a source region and a drain region, the source region and the drain region having a second conductivity type and being provided in the semiconductor layer, and
the first semiconductor region is in contact with the source region or the drain region in the transistor.

3. The photodetector according to claim 2, wherein
the first semiconductor region comprises a p-type semiconductor region, and
the source region and the drain region each comprise an n-type semiconductor region.

4. The photodetector according to claim 1, wherein
the transistor includes a gate electrode and a gate insulating film, and
the first semiconductor region is provided to be adjacent to at least one of the gate electrode or the gate insulating film in the transistor.

5. The photodetector according to claim 1, comprising a first well, the first well having the first conductivity type and being provided in the semiconductor layer, wherein
the first semiconductor region is provided in the first well, and
the first contact is electrically coupled to the first well via the first semiconductor region.

6. The photodetector according to claim 1, comprising a conductor region, the conductor region being in contact with a portion of the first semiconductor region and being provided inside the trench, wherein
the first contact is provided on the conductor region, the first contact being electrically coupled to the first semiconductor region via the conductor region.

7. The photodetector according to claim 6, wherein the conductor region is provided in the semiconductor layer.

8. The photodetector according to claim 1, wherein
the plurality of pixels includes a second pixel adjacent to the first pixel, and
the first pixel and the second pixel each include the photoelectric conversion element, a floating diffusion, the transistor, and the first semiconductor region.

9. The photodetector according to claim 8, comprising a conductor region, the conductor region electrically coupling the first semiconductor region in the first pixel and the first semiconductor region in the second pixel.

10. The photodetector according to claim 8, comprising:
a second semiconductor region, the second semiconductor region electrically coupling the floating diffusion in the first pixel and the floating diffusion in the second pixel; and
a second contact that is electrically coupled to the second semiconductor region.

11. The photodetector according to claim 1, comprising a reading circuit, the reading circuit including the transistor and being configured to output a signal, the signal being based on electric charge that is photoelectrically converted by the photoelectric conversion element.

12. The photodetector according to claim 11, wherein the transistor comprises an amplifying transistor, a selection transistor, a reset transistor, a switching transistor, or a dummy transistor.

13. The photodetector according to claim 1, comprising:
a lens that light enters; and
a first photoelectric conversion element and a second photoelectric conversion element provided adjacent to the first photoelectric conversion element, the first photoelectric conversion element performing photoelectric conversion on the light transmitted through the lens, the second photoelectric conversion element performing photoelectric conversion on the light transmitted through the lens, the first photoelectric conversion element and the second photoelectric conversion element each being provided as the photoelectric conversion element.

14. The photodetector according to claim 13, comprising:
a first transistor; and
a second transistor provided adjacent to the first transistor,
the first transistor and the second transistor each being provided as the transistor, wherein
the first semiconductor region is in contact with the first transistor and the second transistor.

15. The photodetector according to claim 14, wherein
the first transistor is provided on a side of the first photoelectric conversion element, the first transistor including a source region and a drain region each having a second conductivity type,
the second transistor is provided on a side of the second photoelectric conversion element, the second transistor including a source region and a drain region each having the second conductivity type, and
the first semiconductor region is in contact with the source region or the drain region in the first transistor, and with the source region or the drain region in the second transistor.

16. The photodetector according to claim 14, wherein
the first transistor and the second transistor each include a gate electrode and a gate insulating film, and
the first semiconductor region is provided to be adjacent to at least one of the gate electrode or the gate insulating film in the first transistor, and to at least one of the gate electrode or the gate insulating film in the second transistor.

17. The photodetector according to claim 16, wherein
the first contact is provided between a source region or a drain region in the first transistor and a source region or a drain region in the second transistor.

18. The photodetector according to claim 14, comprising a reading circuit, the reading circuit including the first transistor and the second transistor and being configured to output a signal based on electric charge photoelectrically converted by the first photoelectric conversion element and a signal based on electric charge photoelectrically converted by the second photoelectric conversion element.

19. The photodetector according to claim 13, wherein the lens is provided on a side of a second surface of the semiconductor layer, the side of the second surface being opposite to the first surface.

20. A photodetector, comprising:
a first pixel provided in a semiconductor layer; and
a trench including a first region and a second region, the first region separating the first pixel and an adjacent pixel, and the second region being a region in which a photoelectric conversion element provided in the first pixel is shielded in a plan view, wherein
the second region, in the plan view, includes a first separator between a first floating diffusion region and a second floating diffusion region, the first floating diffusion region and the second floating diffusion region being provided in the first pixel,
the second region, in the plan view, includes a second separator between a first transistor and a second transistor, the first transistor and the second transistor being provided in the first pixel,
the first pixel includes a first semiconductor region and a first contact, the first semiconductor region having a first conductivity type, and the first contact being electrically coupled to the first semiconductor region,
the first semiconductor region is provided between the first separator and the second separator in the plan view, and
the first semiconductor region is in contact with the first transistor and the second transistor.

21. The photodetector according to claim 20, wherein
the first transistor and the second transistor each include a gate electrode and a gate insulating film, and
the first semiconductor region is provided to be adjacent to at least one of the gate electrode or the gate insulating film.

22. The photodetector according to claim 20, wherein the first semiconductor region, in the plan view, includes a first part and a second part, the first part being in contact with the first transistor and the second transistor in a horizontal direction, and the second part being in contact with the first part in a vertical direction.

23. The photodetector according to claim 22, wherein the first contact is provided on the second part of the first semiconductor region.

24. The photodetector according to claim 22, wherein the first part has an impurity concentration lower than an impurity concentration of the second part.

25. The photodetector according to claim 20, wherein
the first transistor and the second transistor each include a source region and a drain region, the source region and the drain region being provided in the semiconductor layer and each having a second conductivity type, and
the first semiconductor region is in contact with the source region or the drain region in each of the first transistor and the second transistor.

26. The photodetector according to claim 25, wherein
the first semiconductor region comprises a p-type semiconductor region, and
the source region and the drain region each comprise an n-type semiconductor region.

27. An electronic apparatus, comprising:
an optical system; and
a photodetector that receives light transmitted through the optical system,
the photodetector including
a semiconductor layer,
a plurality of pixels including a first pixel, the first pixel including a photoelectric conversion element provided in the semiconductor layer, and
a trench provided between the plurality of pixels in the semiconductor layer, the plurality of pixels being adjacent to each other, wherein
the first pixel includes a transistor, a first semiconductor region, and a first contact, the transistor being provided on a side of a first surface of the semiconductor layer, the first semiconductor region having a first conductivity type and being provided on the side of the first surface of the semiconductor layer, and the first contact being electrically coupled to the first semiconductor region, and
the first semiconductor region is in contact with the transistor.

28. An electronic apparatus, comprising:
an optical system; and
a photodetector that receives light transmitted through the optical system,
the photodetector including
a first pixel provided in a semiconductor layer, and
a trench including a first region and a second region, the first region separating the first pixel and an adjacent pixel, and the second region being a region in which a photoelectric conversion element provided in the first pixel is shielded in a plan view, wherein
the second region, in the plan view, includes a first separator between a first floating diffusion region and a second floating diffusion region, the first floating diffusion region and the second floating diffusion region being provided in the first pixel,
the second region, in the plan view, includes a second separator between a first transistor and a second transistor, the first transistor and the second transistor being provided in the first pixel,
the first pixel includes a first semiconductor region and a first contact, the first semiconductor region having a first conductivity type, and the first contact being electrically coupled to the first semiconductor region,
the first semiconductor region is provided between the first separator and the second separator in the plan view, and
the first semiconductor region is in contact with the first transistor and the second transistor.
